# EUROPEAN PATENT APPLICATION

(11) **EP 4 765 628 A1**
(43) Date of publication of application: **24.06.2026**
(21) Application number: 25213657.7
(22) Date of filing: 05.11.2025
(51) Int. Cl.: H03B 5/12, H03B 5/32, H03B 5/36

(54) **RADIO FREQUENCY COMMUNICATION**

(30) Priority: 20.12.2024 US 202418988998
(71) Applicant: INTEL Corporation, Santa Clara, CA 95054 (US)
(72) Inventor: KRONFELD, Ronen, 6081548 Shoham (IL); BERSHANSKY, Sergey, 4256538 Netanya (IL); FARBER, Aryeh, 4970602 Petah Tikva (IL); ISRAEL, Arie, Petah Tikva (IL)
(74) Representative: Viering, Jentschura & Partner mbB Patent- und Rechtsanwälte

(57) **Abstract**

An apparatus may include: a resonator configured to oscillate at a resonant frequency; and a first oscillator core and a second oscillator core coupled to the resonator in a parallel configuration; wherein the first oscillator core configured to drive the resonator by providing a first drive signal and generate a first oscillator signal based on oscillations of the resonator; and wherein the second oscillator core configured to drive the resonator by providing a second drive signal and generate a second oscillator signal based on the oscillations of the resonator.

## Description

### Background

In radio communication networks in accordance with many radio communication technologies, such as wireless local area network (WLAN or Wi-Fi), Bluetooth, fourth generation long term evolution (LTE), and fifth generation (5G) new radio (NR), various methods are employed to provide wireless data transfer with desired efficiency, speed, and reliability. These networks require robust design and implementation of radio frequency (RF) components to achieve desired performance characteristics, including low power consumption, high bandwidth, and minimal interference. The successful deployment and operation of these technologies may rely on the design and implementation of RF components.

One of the core elements associated with these RF components may include the generation of reference clocks, which may enable synchronizing and stabilizing the operation of communication devices and the generation of RF signals. In particular, RF communication circuits, such as those supporting Wi-Fi, Bluetooth, and wide wireless area networks, may require precise clock signals for their functionality. These circuits may often include components such as resonators (e.g., quartz crystal resonators) and oscillator cores to produce the necessary reference clock signals. The design and implementation of these components may affect the overall performance, cost, and complexity of the wireless system.

### Brief Description of the Drawings

In the drawings, like reference characters generally refer to the same parts throughout the different views. The drawings are not necessarily to scale, emphasis instead generally being placed upon illustrating the principles described herein. In the following description, various aspects are described with reference to the following drawings, in which:
FIGs. 1 and 2 depict a general network and device architecture for wireless communications and/or sensing operations;
FIG. 3 shows an exemplary illustration of various communication elements of an apparatus for a wireless communication device;
FIG. 4 shows an exemplary illustration of a transmit path of an RF transceiver;
FIG. 5 illustrates a block diagram of a communication circuitry including two transceivers;
FIG. 6 illustrates a communication circuitry implementing a clock signal cascading configuration;
FIG. 7 shows an illustrative example of a communication circuitry in accordance with various aspects described herein;
FIG. 8 shows an illustrative example of a circuitry in accordance with various aspects described herein;
FIG. 9 illustrates a simplified equivalent circuit in accordance with various aspects described herein;
FIG. 10 illustrates an example of a circuit configuration in accordance with various aspects described herein;
FIG. 11 illustrates a schematic example of an equivalent circuit configuration in accordance with various aspects described herein;
FIG. 12 illustrates a multi-band radio communication circuitry;
FIG. 13 illustrates a multiple input multiple output (MIMO) communication circuit;
FIG. 14 shows an example of a method.

### Description

The following detailed description refers to the accompanying drawings that show, by way of illustration, exemplary details and aspects in which aspects described herein may be practiced.

In radio communication networks that utilize various radio communication technologies, achieving wireless data transfer with desired efficiency, speed, and reliability is essential. These networks may employ multiple methods to meet the increasing demand for high-speed data transmission while maintaining low power consumption and minimal interference. RF communication circuits form the backbone of these networks, enabling the transmission and reception of wireless signals across different frequencies and bands. Specifically, circuits that include a resonator, such as a quartz crystal resonator, and multiple oscillator cores may be crucial for generating precise reference clock signals. These reference clocks may synchronize the operations of transceiver integrated circuits within wireless systems, ensuring accurate timing and coordination across various communication protocols.

Some wireless systems like Wi-Fi, Bluetooth, and wide wireless area networks may include multiple transceiver integrated circuits to support multi-link and/or multi-band operation. This configuration may allow devices to handle multiple communication channels or frequencies simultaneously, enhancing data throughput and reliability. Additionally, some wireless system implementations may include multiple transceiver integrated circuits to support Multiple Input Multiple Output (MIMO) operation, where each integrated circuit may support a single spatial stream. MIMO technology can leverage multiple antennas and transceivers to transmit and receive more than one data signal simultaneously over the same radio channel to increase the capacity and performance of wireless communication systems.

Each transceiver integrated circuit can normally require a reference clock oscillator, which may illustratively include a quartz crystal resonator, connected to an active oscillator core that may be integrated within the transceiver integrated circuit. The quartz crystal resonator can provide a stable frequency reference, while the oscillator core amplifies and maintains the oscillation. This combination can ensure that each transceiver integrated circuit operates synchronously and with the necessary timing precision. However, the inclusion of multiple transceiver integrated circuits may necessitate multiple quartz crystal resonators, each connected to its corresponding integrated circuit.

This requirement may lead to increased system cost and size. Each additional quartz crystal resonator can add to the bill of materials and occupy physical space on the circuit board. In compact devices where space is crucial, such as smartphones and wearable devices, minimizing component count and size may be vital. Moreover, it is sometimes required to synchronize the reference clocks of the different transceiver integrated circuits for proper operation, especially in MIMO configurations. Synchronization can ensure that the multiple data streams transmitted and received by the different integrated circuits are coherently combined to maximize the benefits of MIMO technology. To achieve such a synchronization with separate quartz crystal resonators might impose additional system complexity, increase implementation costs, and contribute to higher power consumption.

To address these challenges, a solution may involve defining one of the transceiver integrated circuits as the primary reference clock generator, which may also be referred to as clock cascading. This primary integrated circuit can connect to a single quartz crystal resonator and generate the reference clock signal. The clock signal is then cascaded or daisy-chained to the other transceiver integrated circuits. This approach may reduce the number of quartz crystal resonators needed but introduces new complexities.

Another solution may include connecting a quartz crystal resonator to multiple integrated circuits, where one of the integrated circuits acts as the oscillator, and the other integrated circuit(s) can use that signal as an external clock. This configuration can eliminate the need for each integrated circuit to have its own quartz crystal resonator, potentially reducing cost and size. However, both of these solutions may present significant shortcomings that may impact system performance and efficiency.

Clock cascading may require activating the reference clock generator in the primary transceiver integrated circuit even when it is inactive regarding data processing. This necessity may increase the system complexity in terms of power and control flow management. The system must ensure that the primary integrated circuit remains powered and operational solely to provide the clock signal to the other integrated circuits, which might not be efficient from a power consumption standpoint. This continuous activation may lead to unnecessary energy expenditure, particularly when the primary integrated circuit is not otherwise in use.

Additionally, clock cascading can require adding clock output buffer(s) to enable driving the reference clock from the primary transceiver integrated circuit to the other transceiver integrated circuits. These buffers may increase the pinout of the transceiver integrated circuit, adding complexity to the integrated circuit design and potentially increasing manufacturing costs. The additional pins and circuitry occupy more space on the integrated circuit and the circuit board, which may be undesirable in compact device designs. Moreover, driving the clock signal through buffers and over interconnections can degrade the clock quality. Issues such as clock phase noise (jitter) may arise, and clock harmonic spurious emissions might be introduced when passing the clock from one integrated circuit to another. These degradations can negatively impact the performance and reliability of the wireless communication system, potentially leading to data errors or reduced communication efficiency.

The alternative solution of connecting a quartz crystal resonator to one integrated circuit operated as the oscillator, while the other integrated circuit(s) use that signal as an external clock, also presents certain challenges. This setup may achieve degraded phase noise performance compared with the single integrated circuit case. The degradation can arise due to higher parasitic capacitance loading from connecting multiple integrated circuits to the same quartz crystal resonator. The increased load may affect the oscillator's ability to maintain a stable and precise frequency. Additionally, the oscillator core might not provide sufficient drive level to handle the increased load, which may further compromise the clock signal's integrity. The insufficient drive level may result in a weaker oscillation, making the system more susceptible to interference and reducing overall signal quality.

These shortcomings may highlight the need for an improved solution that can reduce system cost and size without introducing significant complexities or performance degradations. In accordance with various aspects described herein, a circuitry may be provided, which includes a resonator (e.g. a single resonator, such as a single quartz crystal resonator) connected to multiple oscillator cores in multiple transceivers (e.g. transceiver integrated circuits) in parallel. By activating one or more of the oscillator cores or transceivers, the circuitry may generate a shared and synchronized reference clock. This configuration may allow flexibility in system operation to enable any of the transceivers to be activated individually while maintaining synchronization across the system. For practical reasons, such as routing constraints and parasitic capacitances, aspects described herein may work best in the case of two transceivers coupled to the resonator, but this should not be taken as limiting. The physical layout of the circuit board may limit the feasibility of connecting more than two integrated circuits in this manner without introducing excessive parasitic effects. However, aspects described herein are also applicable to more than two transceivers, especially in low-frequency oscillators and in systems that may require moderate or compromised phase noise (jitter) performance. In applications, where ultra-high precision may not be critical, extending the concept to multiple integrated circuits may provide acceptable performance while still offering the benefits of reduced cost and size.

By connecting the quartz crystal resonator to multiple oscillator cores in parallel, the circuitry may leverage the combined drive capabilities of the activated oscillator cores. Each additional oscillator core that is activated may increase the drive level of the quartz crystal resonator, which may contribute to overcoming parasitic losses and maintaining clock quality, such as phase noise (jitter). The increased drive level can enhance the oscillation amplitude, making the clock signal more robust against interference and ensuring stable operation across the connected integrated circuits.

Aspects described herein may allow the use of a single resonator (e.g. single quartz crystal oscillator) for multiple transceivers, which may result in reducing the overall solution cost and size. Aspects may not require adding further pins to the transceivers, and may simplify the integrated circuit design and potentially reduce manufacturing costs. By avoiding additional pins and external buffers, the circuitry can maintain a compact form factor, which may be beneficial for devices where space is limited. Moreover, aspects described herein may enable activating any of the transceivers individually from the others, while minimizing overall system complexity, control flows, and power consumption. Such an independence may allow for flexible system operation, where individual transceivers (e.g. transceiver integrated circuits) may be powered down when not in use, conserving energy without disrupting the synchronized clock signal.

In some aspects, the signal waveform at the interface ports between the quartz crystal resonator and the oscillator cores may be a clipped sinewave. This waveform may have lower harmonic emissions and interference compared with a square wave clock, which may typically be used for clock cascading between different transceiver integrated circuits. Lower harmonic emissions may reduce the potential for interference with other system components and can improve overall system electromagnetic compatibility (EMC). By minimizing electromagnetic interference, the system may achieve better overall performance and reliability.

Aspects described herein may particularly be beneficial for an implementation in devices where space and power consumption are critical considerations, such as mobile phones, tablets, and Internet of Things (IoT) devices. In these applications, reducing the number of components and simplifying the circuit design can lead to significant advantages in manufacturing and user experience.

The apparatuses and methods described herein may utilize or be related to radio communication technologies. While some examples may refer to specific radio communication technologies, the examples provided herein may be similarly applied to various other radio communication technologies, both existing and not yet formulated, particularly in cases where such radio communication technologies share similar features as disclosed regarding the following examples. Various exemplary radio communication technologies that the apparatuses and methods described herein may utilize include, but are not limited to: a Global System for Mobile Communications ("GSM") radio communication technology, a General Packet Radio Service ("GPRS") radio communication technology, an Enhanced Data Rates for GSM Evolution ("EDGE") radio communication technology, and/or a Third Generation Partnership Project ("3GPP") radio communication technology, for example Universal Mobile Telecommunications System ("UMTS"), Freedom of Multimedia Access ("FOMA"), 3GPP Long Term Evolution ("LTE"), 3GPP Long Term Evolution Advanced ("LTE Advanced"), Code division multiple access 2000 ("CDMA2000"), Cellular Digital Packet Data ("CDPD"), Mobitex, Third Generation (3G), Circuit Switched Data ("CSD"), High-Speed Circuit-Switched Data ("HSCSD"), Universal Mobile Telecommunications System ("Third Generation") ("UMTS (3G)"), Wideband Code Division Multiple Access (Universal Mobile Telecommunications System) ("W-CDMA (UMTS)"), High Speed Packet Access ("HSPA"), High-Speed Downlink Packet Access ("HSDPA"), High-Speed Uplink Packet Access ("HSUPA"), High Speed Packet Access Plus ("HSPA+"), Universal Mobile Telecommunications System-Time-Division Duplex ("UMTS-TDD"), Time Division-Code Division Multiple Access ("TD-CDMA"), Time Division-Synchronous Code Division Multiple Access ("TD-CDMA"), 3rd Generation Partnership Project Release 8 (Pre-4th Generation) ("3GPP Rel. 8 (Pre-4G)"), 3GPP Rel. 9 (3rd Generation Partnership Project Release 9), 3GPP Rel. 10 (3rd Generation Partnership Project Release 10) , 3GPP Rel. 11 (3rd Generation Partnership Project Release 11), 3GPP Rel. 12 (3rd Generation Partnership Project Release 12), 3GPP Rel. 13 (3rd Generation Partnership Project Release 13), 3GPP Rel. 14 (3rd Generation Partnership Project Release 14), 3GPP Rel. 15 (3rd Generation Partnership Project Release 15), 3GPP Rel. 16 (3rd Generation Partnership Project Release 16), 3GPP Rel. 17 (3rd Generation Partnership Project Release 17), 3GPP Rel. 18 (3rd Generation Partnership Project Release 18), 3GPP 4G, 3GPP LTE Extra, LTE-Advanced Pro, LTE Licensed-Assisted Access ("LAA"), MuLTEfire, UMTS Terrestrial Radio Access ("UTRA"), Evolved UMTS Terrestrial Radio Access ("E-UTRA"), Long Term Evolution Advanced (4th Generation) ("LTE Advanced (4G)"), cdmaOne ("2G"), Code division multiple access 2000 (Third generation) ("CDMA2000 (3G)"), Evolution-Data Optimized or Evolution-Data Only ("EV-DO"), Advanced Mobile Phone System (1st Generation) ("AMPS (1G)"), Total Access Communication arrangement/Extended Total Access Communication arrangement ("TACS/ETACS"), Digital AMPS (2nd Generation) ("D-AMPS (2G)"), Push-to-talk ("PTT"), Mobile Telephone System ("MTS"), Improved Mobile Telephone System ("IMTS"), Advanced Mobile Telephone System ("AMTS"), OLT (Norwegian for Offentlig Landmobil Telefoni, Public Land Mobile Telephony), MTD (Swedish abbreviation for Mobiltelefonisystem D, or Mobile telephony system D), Public Automated Land Mobile ("Autotel/PALM"), ARP (Finnish for Autoradiopuhelin, "car radio phone"), NMT (Nordic Mobile Telephony), High capacity version of NTT (Nippon Telegraph and Telephone) ("Hicap"), Cellular Digital Packet Data ("CDPD"), Mobitex, DataTAC, Integrated Digital Enhanced Network ("iDEN"), Personal Digital Cellular ("PDC"), Circuit Switched Data ("CSD"), Personal Handy-phone System ("PHS"), Wideband Integrated Digital Enhanced Network ("WiDEN"), iBurst, Unlicensed Mobile Access ("UMA"), also referred to as also referred to as 3GPP Generic Access Network, or GAN standard), Zigbee, Bluetooth^{®}, Wireless Gigabit Alliance ("WiGig") standard, mmWave standards in general (wireless systems operating at 10-300 GHz and above such as WiGig, IEEE 802.11ad, IEEE 802.11ay, etc.), technologies operating above 300 GHz and THz bands, (3GPP/LTE based or IEEE 802.11p and other) Vehicle-to-Vehicle ("V2V") and Vehicle-to-X ("V2X") and Vehicle-to-Infrastructure ("V2I") and Infrastructure-to-Vehicle ("I2V") communication technologies, 3GPP cellular V2X, DSRC (Dedicated Short Range Communications) communication arrangements such as Intelligent-Transport-Systems, and other existing, developing, or future radio communication technologies.

The apparatuses and methods described herein may use such radio communication technologies according to various spectrum management schemes, including, but not limited to, dedicated licensed spectrum, unlicensed spectrum, (licensed) shared spectrum (such as LSA = Licensed Shared Access in 2.3-2.4 GHz, 3.4-3.6 GHz, 3.6-3.8 GHz and further frequencies and SAS = Spectrum Access System in 3.55-3.7 GHz and further frequencies), and may use various spectrum bands including, but not limited to, IMT (International Mobile Telecommunications) spectrum (including 450-470 MHz, 690-960 MHz, 1710-2025 MHz, 2110-2200 MHz, 2300-2400 MHz, 2500-2690 MHz, 698-790 MHz, 610-790 MHz, 3400-3600 MHz, etc., where some bands may be limited to specific region(s) and/or countries), IMT-advanced spectrum, IMT-2020 spectrum (expected to include 3600-3800 MHz, 3.5 GHz bands, 600 MHz bands, bands within the 24.25-86 GHz range, etc.), spectrum made available under FCC's "Spectrum Frontier" 4G initiative (including 27.5-28.35 GHz, 29.1-29.25 GHz, 31-31.3 GHz, 37-38.6 GHz, 38.6-40 GHz, 42-42.5 GHz, 47-64 GHz, 64-71 GHz, 61-76 GHz, 81-86 GHz and 92-94 GHz, etc.), the ITS (Intelligent Transport Systems) band of 4.9 GHz (typically 4.85-5.925 GHz) and 63-64 GHz, bands currently allocated to WiGig such as WiGig Band 1 (57.24-59.40 GHz), WiGig Band 2 (59.40-61.56 GHz) and WiGig Band 3 (61.56-63.72 GHz) and WiGig Band 4 (63.72-65.88 GHz), the 60.2 GHz-71 GHz band, any band between 65.88 GHz and 61 GHz, bands currently allocated to automotive radar applications such as 66-81 GHz, and future bands including 94-300 GHz and above. Furthermore, the apparatuses and methods described herein can also employ radio communication technologies on a secondary basis on bands such as the TV White Space bands (typically below 690 MHz) where e.g. the 400 MHz and 600 MHz bands are prospective candidates. Besides cellular applications, specific applications for vertical markets may be addressed such as PMSE (Program Making and Special Events), medical, health, surgery, automotive, low-latency, drones, etc. applications. Furthermore, the apparatuses and methods described herein may also use radio communication technologies with a hierarchical application, such as by introducing a hierarchical prioritization of usage for different types of users (e.g., low/medium/high priority, etc.), based on a prioritized access to the spectrum e.g., with highest priority to tier-1 users, followed by tier-2, then tier-3, etc. users, etc. The apparatuses and methods described herein can also use radio communication technologies with different Single Carrier or OFDM flavors (CP-OFDM, SC-FDMA, SC-OFDM, filter bank-based multicarrier (FBMC), OFDMA, etc.) and e.g. 3GPP NR (New Radio), which can include allocating the OFDM carrier data bit vectors to the corresponding symbol resources.

Radio communication technologies described herein may be classified as one of a short range radio communication technology or cellular wide area radio communication technology. Short range radio communication technologies may include Bluetooth, WLAN (e.g., according to any IEEE 802.11 standard), and other similar radio communication technologies. Cellular Wide Area radio communication technologies may include Global System for Mobile Communications ("GSM"), Code Division Multiple Access 2000 ("CDMA2000"), Universal Mobile Telecommunications System ("UMTS"), Long Term Evolution ("LTE"), General Packet Radio Service ("GPRS"), Evolution-Data Optimized ("EV-DO"), Enhanced Data Rates for GSM Evolution ("EDGE"), High Speed Packet Access (HSPA; including High Speed Downlink Packet Access ("HSDPA"), High Speed Uplink Packet Access ("HSUPA"), HSDPA Plus ("HSDPA+"), and HSUPA Plus ("HSUPA+")), Worldwide Interoperability for Microwave Access ("WiMax") (e.g., according to an IEEE 802.16 radio communication standard, e.g., WiMax fixed or WiMax mobile), etc., and other similar radio communication technologies. Cellular wide area radio communication technologies also include "small cells" of such technologies, such as microcells, femtocells, and picocells. Cellular wide area radio communication technologies may be generally referred to herein as "cellular" communication technologies.

In the context of WLAN, the apparatuses and methods described herein may be for various wireless devices, including access points (APs) and wireless station devices (STAs), each may be equipped with radio frequency (RF) communication capabilities. These devices may incorporate transmission and reception components designed to handle RF signals within specified bandwidths and channels as described herein. The communication components typically include both hardware elements and software implementations for signal processing, enabling modulation and demodulation according to specified communication protocols. These devices may particularly be configured to operate under various wireless communication standards, including those developed by the Institute of Electrical and Electronics Engineers (IEEE) for Wi-Fi applications. The RF components, working in conjunction with antenna systems, enable communication across multiple frequency bands. These frequency bands may include, among others, the 2.4 GHz band supporting protocols such as IEEE 802.11b/g/n/ax, the 5 GHz band supporting IEEE 802.11n/ac/ax/be, and the 6 GHz band supporting newer standards like IEEE 802.11ax/be. Additional operational frequencies may extend to 60 GHz (supporting IEEE 802.11ad/ay) and 800 MHz (supporting IEEE 802.11ah), with antenna systems capable of operating at frequencies such as 28 GHz and 40 GHz. Beyond these specified standards, the devices may support emerging Wi-Fi protocols and alternative wireless communication technologies. These alternatives may include, but are not limited to, Bluetooth technology, dedicated short-range communication systems, Ultra-High Frequency applications (including IEEE 802.11af and IEEE 802.22), and white band frequency utilization. The RF reception chain may typically incorporate essential components such as low noise amplifiers, signal amplification stages, analog-to-digital conversion systems, data buffering mechanisms, and digital baseband processing units, all configured to ensure effective wireless communication capabilities.

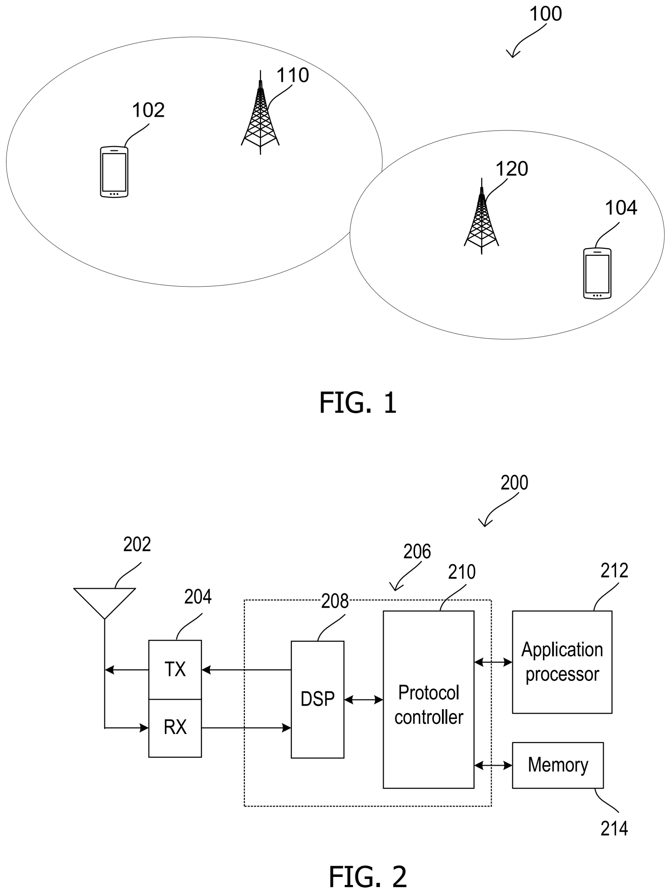

FIGs. 1 and 2 depict a general network and device architecture for wireless communications and/or sensing operations. In particular, FIG. 1 shows exemplary radio communication network 100 according to some aspects, which may include terminal devices 102 and 104 and network access nodes 110 and 120 (e.g. radio access nodes). Radio communication network 100 may communicate with terminal devices 102 and 104 via network access nodes 110 and 120 over a radio access network. Each of terminal devices 102 and 104 or network access nodes 110 and 120 may be a sensing communication device as described herein that may perform a sensing operation. Although certain examples described herein may refer to a particular radio access network context (e.g., 6G, 5G NR, LTE, UMTS, GSM, other 3rd Generation Partnership Project (3GPP) networks, WLAN/WiFi, Bluetooth, millimeter wave, etc.), these examples are demonstrative and may therefore be readily applied to any other type or configuration of radio access network. The number of network access nodes and terminal devices in radio communication network 100 is exemplary and is scalable to any amount.

In an exemplary cellular context, network access nodes 110 and 120 may be base stations (e.g., eNodeBs, NodeBs, Base Transceiver Stations (BTSs), gNodeBs, or any other type of base station), while terminal devices 102 and 104 may be cellular terminal devices (e.g., Mobile Stations (MSs), User Equipments (UEs), or any type of cellular terminal device). Network access nodes 110 and 120 may therefore interface (e.g., via backhaul interfaces) with a cellular core network such as an Evolved Packet Core (EPC, for LTE), Core Network (CN, for UMTS), or other cellular core networks, which may also be considered part of radio communication network 100. The cellular core network may interface with one or more external data networks. In an exemplary short-range context, network access node 110 and 120 may be access points (APs, e.g., WLAN or WiFi APs), while terminal device 102 and 104 may be short range terminal devices (e.g., stations (STAs)). Network access nodes 110 and 120 may interface (e.g., via an internal or external router) with one or more external data networks. Network access nodes 110 and 120 and terminal devices 102 and 104 may include one or multiple transmission/reception points (TRPs).

Network access nodes 110 and 120 (and, optionally, other network access nodes of radio communication network 100 not explicitly shown in FIG. 1) may accordingly provide a radio access network to terminal devices 102 and 104 (and, optionally, other terminal devices of radio communication network 100 not explicitly shown in FIG. 1). In an exemplary cellular context, the radio access network provided by network access nodes 110 and 120 may enable terminal devices 102 and 104 to wirelessly access the core network via radio communications. The core network may provide switching, routing, and transmission, for traffic data related to terminal devices 102 and 104, and may further provide access to various internal data networks (e.g., control nodes, routing nodes that transfer information between other terminal devices on radio communication network 100, etc.) and external data networks (e.g., data networks providing voice, text, multimedia (audio, video, image), and other Internet and application data). Furthermore, terminal devices 102 and 104 and network access nodes 110 and 120 may perform a sensing operation, particularly radar sensing, in accordance with JCAS architecture. In an exemplary short-range context, the radio access network provided by network access nodes 110 and 120 may provide access to internal data networks (e.g., for transferring data between terminal devices connected to radio communication network 100) and external data networks (e.g., data networks providing voice, text, multimedia (audio, video, image), and other Internet and application data).

In accordance with various aspects described herein, network access nodes 110 and 120 and terminal devices 102 and 104 performing their respective sensing operations in a manner, such that each device may perform its respective sensing operation according to its respective sensing signal configuration. Accordingly, each of these devices may generate and transmit its respective sensing signals according to a respective configuration that may include at least one of frequency resources used to transmit sensing signals, the bandwidth of the sensing signals, transmit power of the sensing signals, and waveform shape of the sensing signals which the respective device may determine before generating and/or transmitting the sensing signals. In some examples, a central orchestrator (e.g. a sensing orchestrator) may determine a respective sensing signal configuration for each device and send information representing the respective sensing signal configuration to the respective device.

The radio access network and core network (if applicable, such as for a cellular context) of radio communication network 100 may be governed by communication protocols that can vary depending on the specifics of radio communication network 100. Such communication protocols may define the scheduling, formatting, and routing of both user and control data traffic through radio communication network 100, which includes the transmission and reception of such data through both the radio access and core network domains of radio communication network 100. Accordingly, terminal devices 102 and 104 and network access nodes 110 and 120 may follow the defined communication protocols to transmit and receive data over the radio access network domain of radio communication network 100, while the core network may follow the defined communication protocols to route data within and outside of the core network. Exemplary communication protocols include 6G, 5G NR, LTE, UMTS, GSM, WiMAX, Bluetooth, WiFi, mmWave, etc., any of which may be applicable to radio communication network 100.

FIG. 2 shows an exemplary internal configuration of a communication device (e.g. a sensing communication device) according to various aspects described herein. The communication device may include various aspects of radio communication devices (e.g. network access nodes 110, 120) or various aspects of mobile radio communication devices (e.g. terminal device 102, 104) as well. The communication device 200 may include antenna system 202, radio frequency (RF) transceiver 204, baseband modem 206 (including digital signal processor 208 and protocol controller 210), application processor 212, and memory 214. Although not explicitly shown in FIG. 2, in some aspects communication device 200 may include one or more additional hardware and/or software components, such as processors/microprocessors, controllers/microcontrollers, other specialty or generic hardware/processors/circuits, peripheral device(s), memory, power supply, external device interface(s), subscriber identity module(s) (SIMs), user input/output devices (display(s), keypad(s), touchscreen(s), speaker(s), external button(s), camera(s), microphone(s), etc.), or other related components.

Communication device 200 may transmit and receive radio signals on one or more radio access networks. Baseband modem 206 may direct such communication functionality of communication device 200 according to the communication protocols associated with each radio access network, and may execute control over antenna system 202 and RF transceiver 204 to transmit and receive radio signals according to the formatting and scheduling parameters defined by each communication protocol. Although various practical designs may include separate communication components for each supported radio communication technology (e.g., a separate antenna, RF transceiver, digital signal processor, and controller), for purposes of conciseness the configuration of communication device 200 shown in FIG. 2 depicts only a single instance of such components.

Communication device 200 may transmit and receive wireless signals with antenna system 202. Antenna system 202 may be a single antenna or may include one or more antenna arrays that each include multiple antenna elements. For example, antenna system 202 may include an antenna array at the top of communication device 200 and a second antenna array at the bottom of communication device 200. In some aspects, antenna system 202 may additionally include analog antenna combination and/or beamforming circuitry. In the receive (RX) path, RF transceiver 204 may receive analog radio frequency signals from antenna system 202 and perform analog and digital RF front-end processing on the analog radio frequency signals to produce digital baseband samples (e.g., in-phase/quadrature (IQ) samples) to provide to baseband modem 206. RF transceiver 204 may include analog and digital reception components including amplifiers (e.g., low noise amplifiers (LNAs)), filters, RF demodulators (e.g., RF IQ demodulators), and analog-to-digital converters (ADCs), which RF transceiver 204 may utilize to convert the received radio frequency signals to digital baseband samples. In the transmit (TX) path, RF transceiver 204 may receive digital baseband samples from baseband modem 206 and perform analog and digital RF front-end processing on the digital baseband samples to produce analog radio frequency signals to provide to antenna system 202 for wireless transmission. RF transceiver 204 may thus include analog and digital transmission components including amplifiers (e.g., power amplifiers (PAs), filters, RF modulators (e.g., RF IQ modulators), and digital-to-analog converters (DACs), which RF transceiver 204 may utilize to mix the digital baseband samples received from baseband modem 206 and produce the analog radio frequency signals for wireless transmission by antenna system 202. In some aspects, baseband modem 206 may control the radio transmission and reception of RF transceiver 204, including specifying the transmit and receive radio frequencies for operation of RF transceiver 204.

In accordance with various aspects provided herein, the communication device 200 may perform sensing operations within the radio communication network 100. Illustratively, the baseband modem 206 (e.g. the digital signal processor 208) may be configured to perform sensing-related signal processing in addition to traditional communication processing. For example, the baseband modem 206 may be configured to implement techniques like radar waveform generation, matched filtering for target detection, parameter estimation (e.g., range, velocity, angle) of detected targets, and environmental mapping. In some examples, the baseband modem 206 (e.g. the digital signal processor 208) may use its hardware accelerators and parallel processing capabilities to efficiently handle the computationally intensive sensing algorithms alongside communication tasks.

Furthermore, the baseband modem 206 (e.g. the protocol controller 210) may be configured to coordinate and/or manage joint operation of communication and sensing functions. Illustratively, the baseband modem 206 may schedule sensing and communication operations, allocate resources (e.g., time/frequency resources, antenna beams) between the sensing operations and the communication operations, and manage interference between them. The baseband modem (e.g. the protocol controller 210) may further implement sensing control protocols and interfaces to enable coordination with other network entities for distributed sensing operations as described herein.

In some examples, the application processor 212 may be configured to act as a source and sink for sensing data, similar to its role for communication data. The application processor 212 may execute sensing applications that are configured to process and interpret the sensing data received from the baseband modem 206. Illustratively, the application processor 212 may perform at least one of object detection and tracking, environmental mapping, and/or situational awareness services using the sensing data. In some examples, the application processor 212 may interface with external sensors (e.g., cameras, lidars) to fuse data from multiple sensing modalities for enhanced perception capabilities.

Correspondingly, the RF transceiver 204 may further support the transmission and reception of sensing waveforms in addition to communication signals. Illustratively, the RF transceiver 204 may generate and transmit sensing signals (e.g., frequency-modulated continuous waveforms for radar), and may process the received sensing signals to extract target information. In some examples, the RF transceiver 204 can use the same analog and digital components (e.g., amplifiers, filters, modulators/demodulators, ADCs/DACs) for sensing operations and the communication operations, potentially with additional hardware accelerators for sensing-specific tasks. Illustratively, the antenna system 202 may also support both communication and sensing functions, in some examples with separate antenna arrays or shared arrays with beamforming capabilities. In accordance with various aspects, the antenna system 202 can form narrow beams for extended sensing range or wide beams for faster coverage, depending on the sensing requirements and resource constraints. Techniques like MIMO and beamforming can be employed to enhance the sensing performance and enable features like high-resolution target parameter estimation and interference mitigation.

As shown in FIG. 2, baseband modem 206 may include digital signal processor 208, which may perform physical layer (PHY, layer 1) transmission and reception processing to, in the transmit path, prepare outgoing transmit data provided by protocol controller 210 for transmission via RF transceiver 204, and, in the receive path, prepare incoming received data provided by RF transceiver 204 for processing by protocol controller 210. Digital signal processor 208 may be configured to perform one or more of error detection, forward error correction encoding/decoding, channel coding and interleaving, channel modulation/demodulation, physical channel mapping, radio measurement and search, frequency and time synchronization, antenna diversity processing, power control and weighting, rate matching/de-matching, retransmission processing, interference cancelation, and any other physical layer processing functions. Digital signal processor 208 may be structurally realized as hardware components (e.g., as one or more digitally-configured hardware circuits or field programmable gate arrays (FPGAs)), software-defined components (e.g., one or more processors configured to execute program code defining arithmetic, control, and I/O instructions (e.g., software and/or firmware) stored in a non-transitory computer-readable storage medium), or as a combination of hardware and software components. In some aspects, digital signal processor 208 may include one or more processors configured to retrieve and execute program code that defines control and processing logic for physical layer processing operations. In some aspects, digital signal processor 208 may execute processing functions with software via the execution of executable instructions. In some aspects, digital signal processor 208 may include one or more dedicated hardware circuits (e.g., application specific integrated circuits (ASICs), field programmable gate arrays, and other hardware) that are digitally configured to specific execute processing functions, where the one or more processors of digital signal processor 208 may offload certain processing tasks to these dedicated hardware circuits, which are known as hardware accelerators. Exemplary hardware accelerators can include fast Fourier transform (FFT) circuits and encoder/decoder circuits. In some aspects, the processor and hardware accelerator components of digital signal processor 208 may be realized as a coupled integrated circuit.

Communication device 200 may be configured to operate according to one or more radio communication technologies. Digital signal processor 208 may be responsible for lower-layer processing functions (e.g., layer 1/PHY) of the radio communication technologies, while protocol controller 210 may be responsible for upper-layer protocol stack functions (e.g., data link layer/layer 2 and/or network layer/layer 3). Protocol controller 210 may thus be responsible for controlling the radio communication components of communication device 200 (antenna system 202, RF transceiver 204, and digital signal processor 208) in accordance with the communication protocols of each supported radio communication technology, and accordingly may represent the access stratum (AS) and non-access stratum (NAS) (also encompassing layer 2 and layer 3) of each supported radio communication technology. Protocol controller 210 may be structurally embodied as a protocol processor configured to execute protocol stack software (retrieved from a controller memory) and subsequently control the radio communication components of communication device 200 to transmit and receive communication signals in accordance with the corresponding protocol stack control logic defined in the protocol software. Protocol controller 210 may include one or more processors configured to retrieve and execute program code that defines the upper-layer protocol stack logic for one or more radio communication technologies, which can include data link layer/layer 2 and network layer/layer 3 functions. Protocol controller 210 may be configured to perform both user-plane and control-plane functions to facilitate the transfer of application layer data to and from radio communication device 200 according to the specific protocols of the supported radio communication technology. User-plane functions can include header compression and encapsulation, security, error checking and correction, channel multiplexing, scheduling, and priority, while control-plane functions may include setup and maintenance of radio bearers. The program code retrieved and executed by protocol controller 210 may include executable instructions that define the logic of such functions.

Communication device 200 may also include application processor 212 and memory 214. Application processor 212 may be a CPU, and may be configured to handle the layers above the protocol stack, including the transport and application layers. Application processor 212 may be configured to execute various applications and/or programs of communication device 200 at an application layer of communication device 200, such as an operating system (OS), a user interface (UI) for supporting user interaction with communication device 200, and/or various user applications. The application processor may interface with baseband modem 206 and act as a source (in the transmit path) and a sink (in the receive path) for user data, such as voice data, audio/video/image data, messaging data, application data, basic Internet/web access data, etc. In the transmit path, protocol controller 210 may therefore receive and process outgoing data provided by application processor 212 according to the layer-specific functions of the protocol stack, and provide the resulting data to digital signal processor 208. Digital signal processor 208 may then perform physical layer processing on the received data to produce digital baseband samples, which digital signal processor may provide to RF transceiver 204. RF transceiver 204 may then process the digital baseband samples to convert the digital baseband samples to analog RF signals, which RF transceiver 204 may wirelessly transmit via antenna system 202. In the receive path, RF transceiver 204 may receive analog RF signals from antenna system 202 and process the analog RF signals to obtain digital baseband samples. RF transceiver 204 may provide the digital baseband samples to digital signal processor 208, which may perform physical layer processing on the digital baseband samples. Digital signal processor 208 may then provide the resulting data to protocol controller 210, which may process the resulting data according to the layer-specific functions of the protocol stack and provide the resulting incoming data to application processor 212. Application processor 212 may then handle the incoming data at the application layer, which can include execution of one or more application programs with the data and/or presentation of the data to a user via a user interface.

Memory 214 may embody a memory component of communication device 200, such as a hard drive or another such permanent memory device. Although not explicitly depicted in FIG. 2, the various other components of communication device 200 shown in FIG. 2 may additionally each include integrated permanent and non-permanent memory components, such as for storing software program code, buffering data, etc.

In accordance with some radio communication networks, terminal devices 102 and 104 may execute mobility procedures to connect to, disconnect from, and switch between available network access nodes of the radio access network of radio communication network 100. As each network access node of radio communication network 100 may have a specific coverage area, terminal devices 102 and 104 may be configured to select and re-select available network access nodes to maintain a strong radio access connection with the radio access network of radio communication network 100. For example, terminal device 102 may establish a radio access connection with network access node 110 while terminal device 104 may establish a radio access connection with network access node 112.

In the event the current radio access connection degrades, terminal devices 102 or 104 may seek a new radio access connection with another network access node of radio communication network 100. For example, terminal device 104 may move from the coverage area of network access node 112 into the coverage area of network access node 110. As a result, the radio access connection with network access node 112 may degrade, which terminal device 104 may detect via radio measurements such as signal strength or signal quality measurements of network access node 112.

Depending on the mobility procedures defined in the appropriate network protocols for radio communication network 100, terminal device 104 may seek a new radio access connection (which may be, for example, triggered at terminal device 104 or by the radio access network), such as by performing radio measurements on neighboring network access nodes to determine whether any neighboring network access nodes can provide a suitable radio access connection. As terminal device 104 may have moved into the coverage area of network access node 110, terminal device 104 may identify network access node 110 (which may be selected by terminal device 104 or selected by the radio access network) and transfer to a new radio access connection with network access node 110. Such mobility procedures, including radio measurements, cell selection/reselection, and handover are established in the various network protocols and may be employed by terminal devices and the radio access network in order to maintain strong radio access connections between each terminal device and the radio access network across any number of different radio access network scenarios.

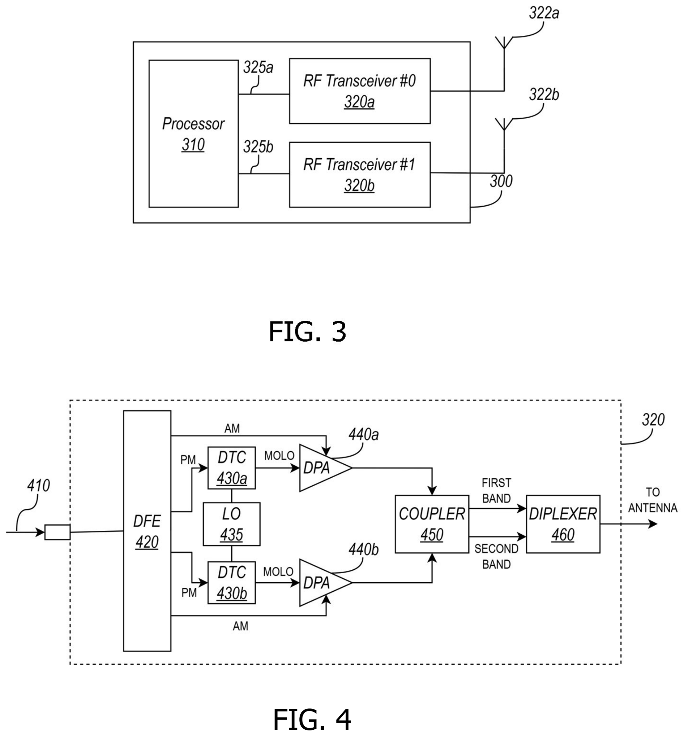

FIG. 3 shows an exemplary illustration of various communication elements of an apparatus for a wireless communication device (e.g. the communication device 200). The apparatus 300 may include processing circuitry 310 (e.g. the baseband modem 206, the application processor 212) that may direct and manage communication operations of the apparatus 300 according to one or more radio communication protocols, and may control transmission/reception of communication signals over at least one or more antenna 322a-b via one or more RF transceivers 320a-b. The processing circuitry 310 may include an interface to the RF transceivers 320a-b. In this example, two RF transceivers, namely a first RF transceiver 320a and a second RF transceiver 320b are illustrated, but the apparatus 300 may include more than two RF transceivers. In an example, each RF transceiver depicted herein may be implemented by a respective integrated circuit (i.e. a transceiver integrated circuit). In accordance with various aspects described herein, the apparatus 300 may include the communication circuitry described herein, which the communication circuitry may include the RF transceivers 320a-b.

Each RF transceiver 320a-b may include at least one RF-chain to process the communication signals associated with the antenna 322a-b respectively. The apparatus 300 may include the first and second antennas 322a-b, or the apparatus 300 may include an antenna interface couplable to these antennas 322a-b. It is to be noted that the apparatus 300 is depicted as being couplable to the antennas 322a-b, but the apparatus 300 may be couplable to more than two antennas, and thereby each RF transceiver 320a-b may include a plurality of RF-chains, each RF-chain may process communication signals for a respective antenna. The apparatus 300 may transmit and receive radio communication signals with the antennas 322a-b. The apparatus 300 may act as an RF transmitter (e.g. RF transmit circuit) to transmit radio communication signals and it may also act as an RF receiver (e.g. RF receive circuit) to receive radio communication signals.

The processing circuitry 310 may include, or may be implemented, partially or entirely, by circuit and/or logic, e.g., a processor including circuit and/or logic, a memory circuit and/or a logic, which may be configured to manage radio communication operations. The processing circuitry 310 may be configured to communicate with an external main processor (e.g. a host processor, a central processing unit, a system on chip) of the wireless communication device including the apparatus 300 via a designated interface that is coupled to the main processor. In some examples, the processing circuitry 310 may be the main processor of the wireless communication device. The processing circuitry 310 may also access the main memory of the respective wireless communication device via the designated interface. The processing circuitry 310 may further include an interface to the RF transceivers 320a-b.

The processing circuitry 310 may include a digital signal processor (e.g. the digital signal processor 208). The digital signal processor 208 may be configured to perform one or more of error detection, forward error correction encoding/decoding, channel coding, and interleaving, channel modulation/demodulation, physical channel mapping, radio measurement and search, frequency and time synchronization, antenna diversity processing, power control, and weighting, rate matching/de-matching, retransmission processing, interference cancelation, and any other physical layer processing functions.

The processing circuitry 310 may include a modem configured to process baseband signals received from/sent to the antennas 322a-b via respective communication paths 325a-b including a corresponding RF chain. In various examples, the interface to the RF transceivers 320a-b of the processing circuitry 310 may be configured to couple the processing circuitry 310 to the communication paths 325a-b. Accordingly, the processing circuitry 310 may include media-access control (MAC) circuit and/or logic, physical layer (PHY) circuit and/or logic, baseband (BB) circuit and/or logic, a baseband processor, a baseband memory, application processor circuit and/or logic, an application processor, an application processor memory, and/or any other circuit and/or logic. By way of example, the processing circuitry 310 can perform baseband processing on the digital baseband signals to recover data included in wireless data transmissions.

The processing circuitry 310 may control and/or arbitrate transmit and/or receive functions of the apparatus 300, and perform one or more baseband processing functions (e.g., MAC, encoding/decoding, modulation/demodulation, data symbol mapping, error correction, etc.). The processing circuitry 310 may be configured to provide control functions to the RF transceivers 320a-b (e.g. to the RF-chain to control and/or arbitrate transmitting and/or receiving radio communication signals). In aspects, functions of processing circuitry 310 can be implemented in software and/or firmware executing on one or more suitable programmable processors, and may be implemented, for example, in a field programmable gate array, application specific integrated circuit, etc. In various examples, the interface to the RF transceivers 320a-b of the processing circuitry 310 may be configured to couple processing circuitry to the RF transceivers 320a-b to provide communication in-between.

Each RF transceiver 320a-b may provide RF processing of communication signals conveyed via a respective communication path 325a-b within a respective RF chain to transmit radio communication signals via a respective antenna based on signals (e.g. baseband communication signals, digital signals) received from the processing circuitry 310 over the communication path. Each RF transceiver 320a-b may provide RF processing of communication signals conveyed via the respective communication path 325a-b to receive radio communication signals via the respective antenna 322a-b and provide signals to the processing circuitry 310 over the respective communication path 325a-b. The processing circuity 310 may be configured to control operations of the RF transceivers 320a-b. Each RF transceiver 320a-b may include a receive path to provide RF processing to receive radio communication signals received from the respective antenna 322a-b, and a transmit path to provide RF processing to transmit radio communication signals transmitted via the respective antenna 322a-b.

In a receive (RX) path, each RF transceiver 320a-b may receive analog radio frequency signals from the respective antenna 322a-b via the respective communication path 325a-b and perform analog and digital RF front-end processing on the analog radio frequency signals to produce digital baseband samples (e.g., In-phase/Quadrature (IQ) samples) to provide to the processing circuitry 310. In various examples, each RF transceiver 320a-b may include two RF-chains per antenna element, each RF-chain may be designated for a particular polarization. Each RF transceiver 320a-b may include analog and digital reception components including amplifiers (e.g., low noise amplifiers (LNAs)), filters, RF demodulators (e.g., RF IQ demodulators)), and analog-to-digital converters (ADCs), which that RF transceiver 320 may utilize to convert the received radio frequency signals to digital baseband samples.

In a transmit (TX) path, each RF transceiver 320a-b may receive digital baseband samples from processing circuitry 310 and perform analog and digital RF front-end processing on the digital baseband samples to produce analog radio frequency signals to be provided to the respective antenna 322a-b via the respective communication path 325a-b for radio transmission. Each RF transceiver 320a-b may thus include analog and digital transmission components including amplifiers (e.g., power amplifiers (PAs), filters, RF modulators (e.g., RF IQ modulators), and digital-to-analog converters (DACs), which that RF transceiver 320 may utilize to mix the digital baseband samples received from processing circuitry 310 and produce respective analog radio frequency signals for radio transmission by the respective antenna 322a-b. In some aspects, the processing circuitry 310 may control the radio transmission and reception of the RF transceivers 320a-b, including specifying the transmit and receive radio frequencies for the operation of each RF transceiver 320a-b. In some examples, at least one of the amplifiers may include an amplifier circuit provided herein.

FIG. 4 shows an exemplary illustration of a transmit path of an RF transceiver configured for dual-band operation. The RF transceiver is referred to here as the RF transceiver 320 and may be the first RF transceiver 320a or the second RF transceiver 320b described in accordance with FIG. 3. The RF transceiver 320, of which its transmit path illustrated herein, may be configured for a digital polar TX for two distinct frequency bands. The RF transceiver 320 may be couplable to processing circuitry (e.g. the processing circuitry 310, a modem) over an interface. The interface may include a communication path designated to carry communication signals 410 between the processing circuitry and an antenna. In some examples, the interface may include a further circuit path to provide communication between the RF transceiver 320 and the processing circuitry for control of the operations. The RF transceiver 320 may further include further components and or circuits, such as further filter circuits, synthesizer circuits, etc. that are not depicted here. The RF transceiver 320 may include various circuits and components deployed on the respective transmission path.

The RF transceiver 320 may include various circuits and components deployed to process and transmit communication signals across two frequency bands. These components may include a digital front end (DFE) 420, digital to time converters (DTCs) 430a and 430b, digital power amplifiers (DPAs) 440a and 440b, a coupler 450 and a diplexer 460.

The digital front end 420 may receive the communication signals 410 via the interface coupling the processing circuitry to the digital front end 420. The digital front end 420 may include a digital front end processing circuitry and further components. The digital front end 420 may be configured to convert the communication signals 410 (e.g. in-phase/quadrature (IQ) signals) into a polar signal including an amplitude modulation (AM) signal (e.g. amplitude control codes) and a phase modulation (PM) signal (e.g. phase control codes). Generated amplitude modulation signals and phase modulation signals may be provided to respective transmit chains for further processing.

In a first transmit chain configured for a first frequency band, the RF transceiver 320 may include a first digital to time converter 430a. The first digital to time converter 430a may be coupled to the digital front end 420. The first digital to time converter 430a may receive the phase modulation signal. The first digital to time converter 430a may be further coupled to a local oscillator (LO) 435. The first digital to time converter 430a may adjust polar modulation parameters based on the PM signal that the digital front end 420 provides to generate a modulated local oscillator signal for the first frequency band. By adjusting the polar modulation parameters based on the PM signal, the first digital to time converter 430a may output a modulated local oscillator (MOLO) signal at the first frequency band. In the first transmit chain, the RF transceiver 320 may further include a first digital power amplifier 440a. The first digital power amplifier 440a may receive the amplitude modulation signal (e.g. amplitude control codes) setting desired power of the output of the first digital power amplifier 440a. The first digital power amplifier 440a may further receive the modulated local oscillator signal at the first frequency band and provide an output RF signal at the first frequency band, which is based on the received modulated local oscillator signal and amplitude modulation signal. The first digital power amplifier 440a may include a dynamic power control, or an RF-capacitive digital to analog converter (RF-CDAC).

In a second transmit chain configured for a second frequency band, the RF transceiver 320 may include a second digital to time converter 430b. The second digital to time converter 430b may be coupled to the digital front end 420. The second digital to time converter 430b may receive the phase modulation signal. The second digital to time converter 430b may be further coupled to the local oscillator 435. The second digital to time converter 430b may adjust polar modulation parameters based on the phase modulation signal that the digital front end 420 provides to generate a modulated local oscillator signal for the second frequency band. By adjusting the polar modulation parameters based on the phase modulation signal, the second digital to time converter 430a may output a modulated local oscillator signal at the second frequency band. In the second transmit chain, the RF transceiver 320 may further include a second digital power amplifier 440b. The second digital power amplifier 440b may receive the amplitude modulation signal (e.g. amplitude control codes) setting desired power of the output of the second digital power amplifier 440b. The second digital power amplifier 440b may further receive the modulated local oscillator signal at the second frequency band and provide an output RF signal at the second frequency band, which is based on the received modulated local oscillator signal and amplitude modulation signal. The second digital power amplifier 440b may include a dynamic power control, or an RF-capacitive digital to analog converter. Although only two transmit chains have been illustrated in the figure, the RF transceiver may include multiple transmit chains, namely more than two transmit chains, such as 3, 4, 5, ..., N, N being an integer.

The local oscillator 435 may include various components to generate a stable and continuous signal at one or more designated frequencies, and may serve as a reference for frequency conversion, mixing and other signal processing tasks. In an example, the local oscillator 435 may include an oscillator core. The oscillator core may generate signals at specified frequencies. An oscillator core may include one or more voltage controlled oscillators which may include tunable oscillators whose frequency can be adjusted by varying a control voltage. The oscillator core may include crystal oscillators that may rely on the mechanical resonance of quartz crystals. The oscillator core may include a dielectric resonator oscillators (DROs).

In some examples, the local oscillator 435 may include a resonator to determine or stabilize the frequency of oscillation. The resonator may include quartz crystals in crystal oscillators or LC circuits or dielectric resonators in voltage controller oscillators. In some examples, the local oscillator 435 may further include phase-locked loops (PLLs) to synchronize the output of the local oscillator 435 with a reference signal to facilitate high accuracy and stability with low phase noise. Illustratively, a phase-locked loop may include a reference oscillator, a phase detector, a low-pass filter, and a VCO or a tunable oscillator. The local oscillator 435 may further include a frequency control circuit that is configured to adjust the output frequency of the local oscillator 435 through various methods, such as manual tuning (e.g. potentiometers), automatic frequency control (AFC), or digital control via microcontrollers, or DSPs (e.g. via the digital front end 420). In accordance with various aspects described herein, the local oscillator 435 may operate with a resonator that is shared with another RF transceiver. Illustratively, referring back to FIG. 4, in an example that the RF transceiver 320 is the first RF transceiver 320a, the second RF transceiver 320b may also be a transceiver that is identical or similar to the RF transceiver 320. A common resonator may be shared by local oscillators (e.g. the local oscillator 435) of these RF transceivers.

The RF transceiver 320 may further include the coupler 450. The coupler 450 may include a dual-band transformer. The coupler 450 may be configured to process RF signals from the first transmit chain and the second transmit chain. Specifically, the coupler 450 may couple the RF signals output by the digital power amplifiers 440a and 440b received by the first end (e.g. input) of the coupler 450 to the second end (e.g. output) of the coupler 450 to further components of the RF transceiver 320, which are coupled to the second end of the coupler while maintaining their respective frequency characteristics. The coupler 450 (e.g. the dual band transformer) may facilitate proper impedance matching for both frequency bands to optimize power transfer and minimize signal reflection.

In other words, the dual band transformer may facilitate impedance matching across both frequency bands to ensure that output impedances of each of first and second transmit chain are matched to subsequent components. The dual band transformer may couple RF signals from both digital power amplifiers 440a and 440b into two distinct outputs corresponding to their respective frequency bands. For example, the signal from digital power amplifier 440a is routed to the first band output and the signal from digital power amplifier 440b is routed to the second band output. The dual-band transformer may operate across the first and second frequency bands by employing impedance transformation techniques tailored for each band.

The RF transceiver 320 may further include the diplexer 460 coupled to the outputs of the coupler 450. The diplexer 460 may combine RF signals from the first band output and second band output of the coupler into a single RF signal for transmission via an antenna. The diplexer 460 may combine the RF signals from the first band output and second band output of the coupler into a single RF signal. In this constellation, the diplexer 460 may include a first terminal at a first end that may receive the first band output, a second terminal at the first end that may receive the second band output, and a terminal at a second end that provides the combined signal. This combined signal is routed to an antenna for transmission. While combining signals, the diplexer 460 may also provide isolation between paths corresponding to different frequency bands to prevent interference or leakage between signals of different bands during transmission.

It is to be noted that while the diplexer 460 is depicted for transmission in this architecture, a diplexer can also support reception by routing incoming RF signals from antennas back to appropriate receive chains based on their frequencies. In a receive RX path of an RF transceiver (e.g. the RF transceiver 320), a diplexer may separate incoming signals based on their frequency bands and route them to appropriate RF chains for further processing. In the above-illustrated diplexer, this time, the diplexer may receive those incoming signals at the terminal at the second end and separate the received incoming signals into two separate signals at two separate frequency bands. In this illustrative example, the diplexer may provide a first signal at the first frequency band from the first terminal at the first end and a second signal at the second frequency from the second terminal at the second end. The diplexer may be a three-port passive RF device that uses filters (e.g., high-pass, low-pass, or band-pass filters) to divide signals into distinct frequency bands. This functionality may enable the RF transceiver to handle multiple frequency bands simultaneously using a shared antenna.

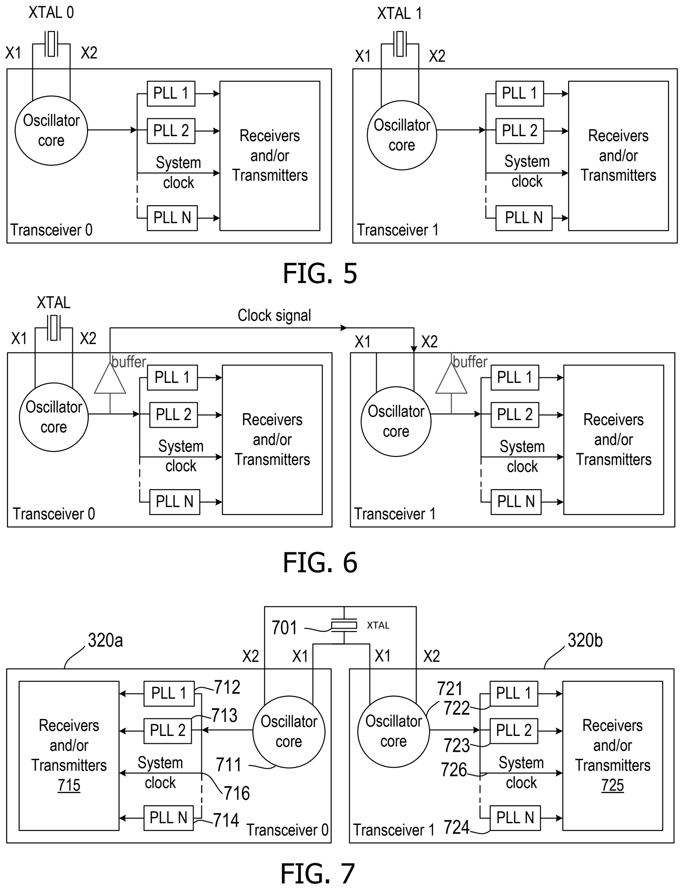

FIG. 5 illustrates a block diagram of a communication circuitry including two transceivers, labeled as transceiver 0 and transceiver 1. Each transceiver includes its own dedicated quartz crystal resonator , an oscillator core, multiple phase-locked loops, and functional blocks for receivers and/or transmitters. The arrangement of components reflects a typical design for generating system clock signals and ensuring independent clocking for each transceiver. Overall, the system depicted in FIG. 5 illustrates a dual-transceiver architecture where each transceiver operates independently with its own quartz crystal resonator.

Transceiver 0 is shown as being connected to a quartz crystal resonator (XTAL 0), which is coupled to the oscillator core of the transceiver. The XTAL 0 is a dual-terminal quartz crystal with terminals labeled as X1 and X2, providing a stable reference frequency for the oscillator core. The oscillator core amplifies and sustains the oscillation provided by XTAL 0 to generate a precise output frequency signal, which is subsequently distributed to multiple phase-locked loops. These phase-locked loops, labeled as PLL 1, PLL 2, and PLL N, operate to generate clock signals with frequencies derived from the oscillator core's output. The output signals from the phase-locked loops serve as system clocks for various operations within the transceiver.

The receivers and/or transmitters associated with Transceiver 0 are functionally connected to the phase-locked loops and utilize the system clocks generated by the phase-locked loops for communication tasks. These components may handle the modulation, demodulation, and signal processing required for transmitting and receiving data over radio frequency (RF) channels. The system clocks may ensure precise timing and synchronization, which are essential for maintaining reliable communication.

Similarly, transceiver 1 is connected to a second quartz crystal resonator (XTAL 1), which is functionally identical to XTAL 0. XTAL 1 also has two terminals, labeled as X1 and X2, and is connected to the oscillator core of transceiver 1. The oscillator core amplifies and stabilizes the oscillation signal generated by XTAL 1 to produce a reference frequency. This frequency is distributed to a set of phase-locked loops, also labeled as PLL 1, PLL 2, and PLL N, within Transceiver 1. These PLLs process the input signal from the oscillator core to produce clock signals tailored to the operational requirements of the transceiver.

The receivers and/or transmitters in transceiver 1 utilize the system clocks generated by the associated phase-locked loops for signal processing, RF transmission, and reception tasks. As with transceiver 0, the system clocks in transceiver 1 provide the necessary timing and synchronization for efficient communication operations. The duplication of quartz crystal resonators, XTAL 0 and XTAL 1, in this architecture ensures that each transceiver can operate individually with its own dedicated reference clock. However, such an arrangement may introduce challenges. For example, the use of separate resonators may lead to increased system cost and size. Furthermore, if the oscillation frequencies of XTAL 0 and XTAL 1 are very similar but not perfectly matched, there may be interference or "beating" between the clocks generated by the two transceivers. This interference can degrade the quality of the communication signals and impact the overall performance of the system. The oscillator cores in both transceivers provide a stable foundation for generating clock signals. They may employ quartz crystal oscillators due to their ability to generate highly stable and precise frequency signals. These signals serve as the basis for the phase-locked loops to synthesize multiple clock frequencies required for different functional blocks within each transceiver.

The receivers and/or transmitters in the transceivers may include analog and digital processing chains. These chains may include amplifiers, filters, and mixers for RF signal processing, as well as digital signal processors for modulation, demodulation, and error correction. The system clocks provided by the phase-locked loops ensure that these processing operations occur with precise timing, which is critical for maintaining synchronization with external communication systems.

FIG. 6 illustrates a communication circuitry implementing a clock signal cascading configuration. In this architecture, transceiver 0 serves as the primary reference clock generator, and transceiver 1 operates using the clock signal cascaded from transceiver 0. The architecture in FIG. 6 represents an approach to reduce component costs and system size by sharing a single quartz crystal resonator across multiple transceivers. Unlike the configuration in FIG. 5, this setup eliminates the need for an independent quartz crystal resonator for transceiver 1, resulting in a reduction in component count and associated costs. However, the design can introduce certain additional components and dependencies between the transceivers.

Transceiver 0 includes a quartz crystal resonator , with terminals X1 and X2, which provides a stable reference frequency signal to the oscillator core. The oscillator core amplifies and stabilizes the oscillation generated by the resonator to produce a reference frequency signal. This signal is then provided to the internal phase-locked loop blocks, labeled as PLL 1, PLL 2, through PLL N, to generate system clocks tailored for internal operations of transceiver 0. These clocks may be used to synchronize the associated receivers and/or transmitters.

Additionally, transceiver 0 includes a clock output buffer, which is configured to drive the reference clock signal to transceiver 1. This buffer ensures that the signal strength and quality are sufficient to transmit the clock signal over the interconnect between the two transceivers. However, the inclusion of the buffer increases the complexity of transceiver 0's design, requiring additional control and power management circuitry. Moreover, the operation of transceiver 0 must remain active to generate and transmit the clock signal, even if its receivers and/or transmitters are not in use.

Transceiver 1, in contrast, does not include an independent quartz crystal resonator. Instead, its oscillator core receives the cascaded clock signal from transceiver 0 via the clock input buffer. The input buffer ensures proper signal reception and prevents signal degradation during transmission. The oscillator core processes this signal and provides it to the internal phase-locked loops, which are configured similarly to those in transceiver 0. The phase-locked loops generate the required system clocks for the receivers and/or transmitters in transceiver 1, enabling synchronized operations across both transceivers.

While the cascading configuration reduces hardware redundancy by using a single quartz crystal resonator, it may introduce potential limitations. The dependency on the primary transceiver (transceiver 0) for clock generation imposes an operational constraint, as any disruption in transceiver 0 directly impacts the functionality of transceiver 1. Furthermore, the inclusion of buffers at both the clock output and input stages may increase the overall power consumption and could degrade clock quality, such as phase noise (jitter) or harmonic spurious emissions, particularly when the clock signal is transmitted over longer distances or through noisy environments.

FIG. 7 shows an illustrative example of a communication circuitry in accordance with various aspects described herein. The communication circuitry may include a single resonator 701 to provide synchronized reference clocks across multiple transceivers. In an example, the resonator 701 may include, or may be, a single quartz crystal resonator. The resonator 701 may be electrically coupled in a parallel configuration to oscillator cores in multiple transceivers. In this illustrative example, the communication circuitry includes two transceivers, namely transceiver 0 320a and transceiver 1 320b. Illustratively, each transceiver 320a-b may be a respective transceiver integrated circuit. Each transceiver 320a-b may include an oscillator core, a set of phase-locked loops, and functional circuitry for transmitting and/or receiving communication signals.

The resonator 701 may oscillate at a certain resonant frequency when driven by one or more of the connected oscillator cores. The resonant frequency of the resonator 701 may be defined by physical and electrical characteristics and may be a predefined resonant frequency that has been illustratively selected with respect to the design considerations and the purpose of the communication device including the communication circuitry. The resonator 701 may be coupled to oscillator core 711 of transceiver 0 320a and oscillator core 721 of transceiver 1 320b through electrical connections to terminals X1 and X2. This parallel configuration may allow both oscillator cores 711, 721 to share the same resonator 701, generating synchronized oscillator signals while maintaining the independence of operation of each transceiver 320a-b. The parallel coupling may eliminate the need for additional clock signal routing or cascading mechanisms.

Oscillator core 711 of transceiver 0 320a (which may be referred to as the first oscillator core) may drive the resonator 711 by providing a first drive signal to maintain oscillation and may generate a first oscillator signal based on the resulting oscillations. In an example, oscillator core 711 may provide the first oscillator signal directly (i.e. without an involvement of any phase-locked loops) to the transmitter and/or receiver circuitry 715 (which may also be referred to as first communication circuit) via a direct path 716 as a system clock. In an example, oscillator core 711 may deliver this first oscillator signal to a series of phase-locked loops, including PLL 1 712, PLL 2 713, and PLL N 714. These phase-locked loops may process the input oscillator signal (i.e. the first oscillator signal) to generate further clock signals that are tailored to the specific requirements of the transmitter and/or receiver circuitry 715 to ensure precise timing and synchronization for communication operations such as modulation, demodulation, encoding, and decoding.

Similarly, in transceiver 1 320b, oscillator core 721 (which may be referred to as the second oscillator core) may drive the same resonator 711 with a second drive signal. Oscillator core 721 may generate a second oscillator signal, which may be used as input for PLL 1 722, PLL 2 723, and PLL N 724. These phase-locked loops may synthesize further clocks that are supplied to the transmitter and/or receiver circuitry 725 (which may also be referred to as second communication circuit) for executing communication functions similarly as described for transceiver 0 320a. In an example, oscillator core 721 may provide the second oscillator signal directly (i.e. without an involvement of any phase-locked loops) to the transmitter and/or receiver circuitry 725 via a direct path 726 as a system clock. The use of a shared resonator may allow that clock signals in both transceivers remain synchronized and may facilitate efficient and coherent operation in systems requiring multi-link or multi-band communication.

A controller of the communication circuitry may be configured to control operation of each oscillator core 711, 721 individually, such that either oscillator core 711, 721 may be activated independent of the other. For example, when only one of the transceivers 320a-b is active, respective oscillator core of the active transceiver alone can drive the resonator 701 to generate the respective oscillator signal for the operation of that transceiver. In an example, when both transceivers 320a-b are active, the combined drive signals from the oscillator cores, namely the first and second oscillator signals of the oscillator cores 711, 721 may enhance the performance of the resonator 701 by compensating for parasitic losses and maintaining clock quality. Such flexibility can reduce unnecessary power consumption while ensuring reliable clock generation.

The transmitter and/or receiver circuitries 715, 725 within each transceiver 320a-b may use the respective clock signals for their respective transmission and reception tasks. These circuitries blocks may include digital-to-analog converters, analog-to-digital converters, amplifiers, filters, and mixers. In particular, these circuitries may include digital power amplifiers, digital to time converters, etc. as described in accordance with FIG. 4. The transmitter and/or receiver circuitries 715 and 725 in the respective transceivers 320a-b may depend on the clock signals for managing various communication operations. These circuitries may perform tasks such as digital modulation, signal amplification, filtering, and analog-to-digital conversion. The synchronized reference clocks provided by the shared resonator may ensure that these operations are performed with precise timing, supporting reliable data transmission and reception in complex communication scenarios.

The resonator 701, illustratively the quartz crystal resonator may be configured to oscillate with a clipped sinewave at the interface including X1 and X2 terminals with oscillator cores 711 and 721. This waveform may inherently reduce harmonic emissions compared to square wave signals to improve electromagnetic compatibility and reduce interference within the circuitry. The clipped sinewave may further contribute to minimizing spurious emissions, enhancing the overall quality of the clock signal distributed to the transceivers.

The phase-locked loops in each transceiver 320a-b may be configured to process the respective received oscillator signals (the first oscillator signal or the second oscillator signal). For example, PLL 1 712, PLL 2 713, and PLL N 714 in transceiver 0 320a may receive the first oscillator signal and use it to generate further clock signals with specific frequencies or phases as required by the transmitter and/or receiver circuitry 715. Similarly, PLL 1 722, PLL 2 723, and PLL N 724 in transceiver 1 320b may process the second oscillator signal to produce further clock signals configured for the transmitter and/or receiver circuitry 725. Each phase-locked loop may include a reference oscillator, a phase detector, a low-pass filter, and a voltage-controlled oscillator for maintaining high stability and accuracy of the output clock signals. In this implementation, the parallel coupling of the resonator 701 to multiple oscillator cores 711, 712 may also facilitate scalability. Although the example illustrated in FIG. 7 focuses on two transceivers, the design can be extended to include additional transceivers, especially in systems operating at lower frequencies or those with relaxed phase noise requirements.

In an example, the resonator 701 may be a single quartz crystal resonator configured to serve as a shared oscillation source for the oscillator cores 711 and 721. The resonator 701 may exhibit a predefined resonant frequency determined by its physical dimensions and material properties to provide a reference clock signal, possibly with minimal frequency deviation over time and temperature variations. The parallel coupling of the single resonator 701 to the first oscillator core 711 of transceiver 0 320a and the second oscillator core 721 of transceiver 1 320b may be facilitated by coupling two ends of the resonator 701 at same respective terminals coupled both of the oscillator cores 711, 721. Both oscillator cores 711, 721 may individually or concurrently drive the resonator 701 to maintain its oscillation, and may produce the first oscillator signal and the second oscillator signal respectively.

In an example, the first oscillator core 711 and the second oscillator core 721 may operate concurrently (i.e. simultaneously). A controller of the communication circuitry may activate both oscillator cores 711 and 721 concurrently. Each oscillator core may generate its respective oscillator signal, while both oscillator cores 711, 721 collectively provide their drive signals to sustain oscillations in the resonator 701. The concurrent operation of the oscillator cores 711, 721 may allow the communication circuitry to maintain synchronization between the transceivers even during multi-link or multi-band communication scenarios. For example, when both transceivers 320a-b are active, the oscillator cores 711, 721 may jointly compensate for parasitic losses in the resonator 701, which may ensure that the quality of the oscillator signals, including phase noise and jitter, remains within acceptable limits.

In an example, the circuitry may include a core controller (not shown) configured to activate the operation of the first oscillator core 711 and the second oscillator core 721. This core controller may be implemented in the communication circuitry as part of the processing circuitry managing the transceivers. The core controller may include logic circuits or programmable elements to selectively activate either one or both oscillator cores 711, 721 based on operational requirements. For instance, the core controller may activate only oscillator core 711 in transceiver 0 320a when transceiver 1 320b is inactive, illustratively to reduce power consumption, while still generating the necessary oscillator signal for the active transceiver. Conversely, when both transceivers are active, the core controller may activate both oscillator cores to ensure synchronized operation and enhanced performance of the resonator 701. In some examples, the processor 310 of the digital front end 420 may include the core controller. For example, the core controller may dynamically switch between activating one or both oscillator cores 711, 712 based on the current communication demands to optimize power efficiency while maintaining synchronization across the transceivers 320a-b.

In an example, the first oscillator core 711 may be electrically coupled to the resonator 701 at a first terminal and a second terminal, and the second oscillator core 721 may be electrically coupled to the resonator 701 at the same terminals. The first terminal may be connected to one end of the resonator 701 while the second terminal may be connected to the other end of the resonator 701. These terminals may serve as common connection points for both oscillator cores, facilitating the parallel coupling configuration. Each oscillator core 711, 721 may interact with the resonator 701 through these terminals to provide its respective drive signal and receive the resultant oscillations of the resonator 701.

Aspects described herein may include that the communication circuitry described herein may include a modular circuitry including the resonator 701 and the oscillator cores 711, 721, which are couplable to a first transceiver circuit via a first interface, in which the first transceiver circuit includes the PLLs 712-714, system clock path 716, and the transmitter and receiver circuitry 715. The modular circuitry may also be couplable to a second , and to a second transceiver circuit via a second interface, in which the second transceiver circuit includes the PLLs 722-724, system clock path 726, and the transmitter and receiver circuitry 725, forming the communication circuitry.

The transmitter and/or receiver circuitry 715 may receive the first oscillator signal and/or outputs of the PLLs 712-714 that are based on the first oscillator signal and perform one or more tasks, such as modulation, demodulation, signal amplification, and filtering, based on the first oscillator signal and/or these phase-locked loop outputs. Similarly, the transmitter and/or receiver circuitry 725 may receive the second oscillator signal and/or outputs of the PLLs 722-724 that are based on the second oscillator signal and perform one or more tasks, such as modulation, demodulation, signal amplification, and filtering, based on the second oscillator signal and/or these phase-locked loop outputs.

In an example, the communication circuitry may further include a transceiver controller (not shown) configured to control the transmitter and/or receiver circuitry 715 and the transmitter and/or receiver circuitry 725. This transceiver controller may be implemented as part of the processing circuitry, coordinating the operation of the transmitter and/or receiver circuitries 715 and 725 based on the communication requirements. For instance, the transceiver controller may adjust the timing, frequency, or power levels of the communication circuits to optimize performance or adapt to changing network conditions. The transceiver controller may also interact with the core controller to ensure that the oscillator cores are activated and synchronized in alignment with the communication circuits' operational states. In an example, the processor 310 may implement the transceiver controller. The transceiver controller may enable dynamic and centralized control over the transmitter and/or receiver circuitries 715, 725. For example, the transceiver controller may synchronize the operation of the transmitter and/or receiver circuitries 715, 725 with the respective oscillator signals generated by the oscillator cores 711, 720 for coherent communication across the transceivers 320a-b.

In an example, the PLLs 712-714, 722-724 may receive their respective oscillator signals, namely the first oscillator signal from oscillator core 711 and the second oscillator signal from oscillator core 721, as input signals. Each PLL 712-714, 722-724 may process the input oscillator signal to generate a respective phase-locked output signal with specific frequencies and phases configured for operational requirements of the respective transmitter and/or receiver circuitry 715, 725. Correspondingly, the phase-locked signals generated by the PLLs 712-714, 722-724 may be used by the respective transmitter and/or receiver circuitries 715, 725 in subsequent operations, such as modulation, demodulation, etc. For example, PLL 1 712 may output a first clock signal optimized for high-frequency modulation to the transmitter and/or receiver circuitry 715, while PLL 2 713 may generate a second clock signal for low-frequency demodulation to be output to the transmitter and/or receiver circuitry 715. Similarly, the phase-locked loops in transceiver 1 320b may provide designated clock signals to the transmitter and/or receiver circuitry 725 for its specific communication tasks. This implementation highlights the ability of the phase-locked loops to enhance the flexibility and performance of the transceiver circuits.

In an example, the transmitter and/or receiver circuitry 715 may include a first radio frequency chain configured to modulate or demodulate one or more first communication signals based on the phase-locked signal received from one or more of the PLLs 712-714, and the transmitter and/or receiver circuitry 725 may include a second radio frequency chain configured to modulate or demodulate the one or more second communication signals based on the further phase-locked signal received from one or more of the PLLs 722-724. Each radio frequency chain may include components such as digital-to-analog converters, analog-to-digital converters, mixers, amplifiers, and filters, which rely on the phase-locked signals generated by the respective phase-locked loops to perform their functions.

For example, the first radio frequency chain in transmitter and/or receiver circuitry 715 may use the phase-locked signal from PLL 1 712 to modulate an outgoing communication signal for transmission (e.g. within the transmit path of the RF transceiver 320). Similarly, the second radio frequency chain in transmitter and/or receiver circuitry 725 may use the phase-locked signal from PLL 1 722 to demodulate an incoming communication signal.

In an example, the circuitry includes an integrated circuit and a package or a printed circuit board, wherein the package or the printed circuit board includes the resonator, and the integrated circuit includes the first oscillator core and the second oscillator core. In an example, the integrated circuit may include the transceivers 320a-b. For example, the resonator 701 may be embedded within the package or the printed circuit board that houses the transceivers 320a and 320b. The integration of the resonator into the package or printed circuit board can reduce the overall footprint of the circuitry, simplify assembly and improve reliability by minimizing external connections. In an example, the oscillator cores 711 and 721, along with their respective phase-locked loops and transmitter and/or receiver circuitries, may be housed within the integrated circuits of transceivers 320a and 320b. These integrated circuits may be coupled to the resonator 701 through terminals X1 and X2, allowing the shared resonator to drive both oscillator cores effectively.

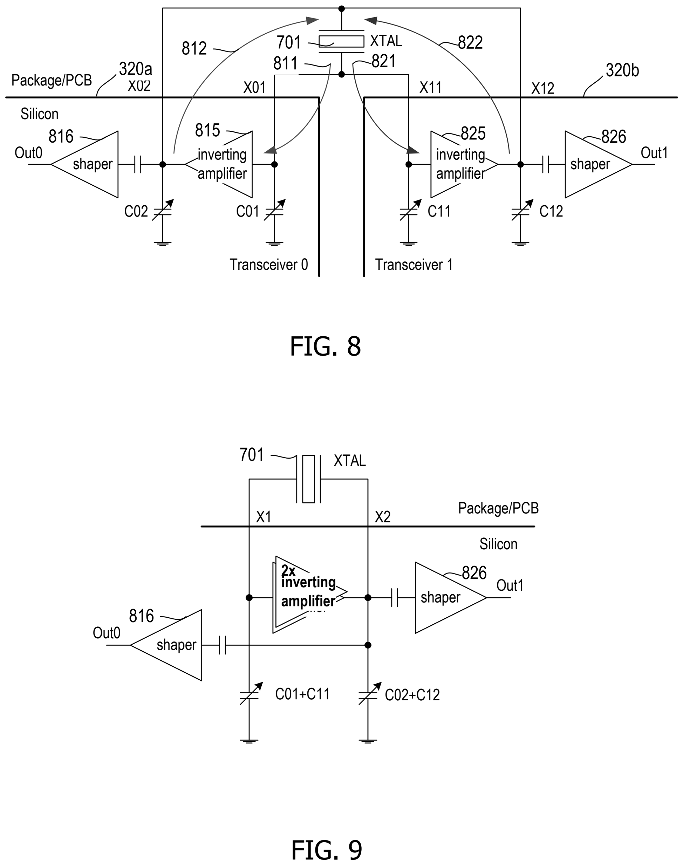

FIG. 8 shows an illustrative example of a circuitry in accordance with various aspects described herein. In an example, the communication circuitry described in accordance with FIG. 7 may include the circuitry. The circuitry illustrated may be considered to depict a more detailed implementation of the parallel coupling of oscillator cores 711, 721 to a shared resonator 701, included bv transceiver 0 320a and transceiver 1 320b. The resonator 701, labeled XTAL, may be configured to oscillate at a predefined resonant frequency and is electrically coupled to the first oscillator core 711 of transceiver 0 320a via terminals X01 and X02 and to the second oscillator core 721 of transceiver 1 320b via terminals X11 and X12.

In an example, the first oscillator core 711 may include an inverting amplifier 815 and a shaper 816. The inverting amplifier 815 may amplify oscillations received from the resonator 701 to generate the first drive signal (e.g. a sinusoidal signal), which may be fed back into the resonator through terminal X01. The shaper 816 may process the amplified first drive signal to transform it into a square wave clock signal, labeled Out0, which may serve as the first oscillator signal. This first oscillator signal may be provided to subsequent components in transceiver 0 320a for further processing. Similarly, the second oscillator core may include an inverting amplifier 825 and a shaper 826. The inverting amplifier 825 may amplify oscillations received from the resonator 701 to generate a second drive signal, which may be fed back into the resonator 701 through terminal X11. The shaper 826 may transform this second drive signal into a square wave clock signal, labeled Out1, which may serve as the second oscillator signal.

The arrows 811 and 812 may represent the electrical coupling between the resonator 701 and the first oscillator core 711 in transceiver 0 320a. Specifically, arrow 811 may represent the path through which the resonator 701 provides oscillations to the input of the inverting amplifier 815. The oscillations may travel from the resonator terminal X01 to the amplifier input. Arrow 812 may represent the feedback path from the output of the inverting amplifier 815 back to the resonator terminal X02, delivering the first drive signal that sustains oscillations in the resonator. Similarly, arrows 821 and 822 illustrate the electrical coupling between the resonator 701 and the second oscillator core 721 in transceiver 1. Arrow 821 may show the path through which oscillations from the resonator 701 are supplied to the input of the second inverting amplifier 825 via terminal X11. Arrow 822 may represent the feedback path from the output of the inverting amplifier 825 to the resonator terminal X12, delivering the second drive signal. These bidirectional paths may form the foundation of the resonator's oscillatory behavior, maintained by the combined or individual operation of the oscillator cores 711, 721.

In an example, each inverting amplifier 815, 825 may receive oscillations from the resonator 701 at its respective input terminal and provide an amplified signal at its respective output terminal. The amplifiers may work together to maintain oscillation of the resonator 701 when both oscillator cores are active, effectively doubling the drive strength provided to the resonator 701. This collective operation may allow the resonator 701 to maintain consistent oscillation despite parasitic losses.

In an example, the circuitry may further include tuning capacitors C01 and C02 for the first oscillator core 711 and tuning capacitors C11 and C12 for the second oscillator core 721. These capacitors may be connected in parallel to the respective terminals of the inverting amplifiers and the resonator, as also illustrated herein. The tuning capacitors may allow precise adjustment of the resonant frequency of the resonator 701. When both oscillator cores 711, 721 are active, the capacitance values of C01 and C11 are summed together, and similarly the capacitance values C02 and C12 are summed together, influencing the frequency of oscillation. This collective tuning mechanism may facilitate that the oscillation frequency remains stable and consistent for both transceivers 320a-b.

In an example, a capacitor controller may be included in the circuitry to manage the tuning capacitors. The capacitor controller may adjust the capacitance of C01, C02, C11, and C12 based on a determination of the oscillator signals' frequencies. For instance, if deviations from the desired resonant frequency are detected, the capacitor controller may fine-tune the capacitance values to bring the frequency back into alignment. Furthermore, the capacitor controller may selectively disconnect one or more capacitors from either oscillator core to individually (separately) manage the frequency characteristics of each core. Illustratively, the processor 310 or the digital front end 420 may include the capacitor controller.

In an example, an inverter controller may further be implemented to manage the operation of the inverting amplifiers 815 and 825. The inverter controller may activate or deactivate each inverting amplifier individually. For example, when only transceiver 0 320a is active, the inverter controller may deactivate the second inverting amplifier 825 while keeping the first inverting amplifier 815 operational. In this scenario, the first inverting amplifier 815 may drive the resonator 701 individually, generating the first oscillator signal. Conversely, when transceiver 1 320b is active, the inverter controller may deactivate the first inverting amplifier 815 and allow the second inverting amplifier 825 to drive the resonator 701. Illustratively, the processor 310 or the digital front end 420 may include the inverter controller.

In an example, the circuitry may be configured to allow the shaper 816 to generate the first oscillator signal based on a signal received at terminal X02 when the first inverting amplifier 815 is deactivated. This functionality may enable the circuitry to maintain clock generation for transceiver 0 320a even when its inverting amplifier 715 is inactive. Similarly, the second shaper 826 may generate the second oscillator signal based on a signal received at terminal X12 when the second inverting amplifier 825 is deactivated.

The resonator 701, which may serve as a shared oscillation source, can operate with a clipped sinewave signal at the interface with terminals X01 and X11. This clipped sinewave signal may inherently reduce harmonic emissions and minimize interference compared to traditional square wave signals, enhancing the electromagnetic compatibility of the circuitry. The shared resonator configuration may also eliminate the need for additional clock routing or cascading mechanisms, simplifying the overall design and reducing system complexity.

FIG. 9 illustrates a simplified equivalent circuit obtainable by the circuitry described in FIG. 8, with particular emphasis on the combined operation of the oscillator cores 711, 721 in transceiver 0 320a and transceiver 1 320b. The resonator 701 is configured as a shared oscillation source for both transceivers 320a-b, coupled through terminals X1 and X2. The resonator 701 may exhibit a predefined resonant frequency determined by its physical and material properties to generate synchronized clock signals. This simplified equivalent circuit configuration demonstrates the combined (e.g. 2x) drive strength provided by both oscillator cores 711, 721 when activated to operate concurrently.

In an example, the inverting amplifier 815 of the first oscillator core 711 may amplify the oscillations received from terminal X1 of the resonator 701. The amplified output may be fed back to terminal X2 of the resonator 701, maintaining oscillations. The second oscillator core 721 may similarly be configured, with its inverting amplifier also coupled between terminals X1 and X2 of the resonator. When both cores 711, 721 are active, the inverting amplifiers 815, 825 operate in tandem, effectively doubling the drive strength applied to the resonator 701.

The respective shaper circuits 816, 826 of each oscillator core 711, 721 may be coupled to the output of its respective inverting amplifier 815, 825. For instance, the shaper circuit 816 associated with the first oscillator core 711 converts the sinusoidal output of the inverting amplifier 815 into a square wave signal labeled Out0. Similarly, the shaper circuit 826 connected to the second oscillator core 721 may generate the square wave output signal Out1. These square wave signals may serve as oscillator signals, driving subsequent components within their respective transceivers.

In an example, the tuning capacitors connected to the input and output of the inverting amplifiers 815, 825 may define the oscillation frequency. The combined tuning capacitance resulting from the summation of individual capacitors (C01 and C11 at one terminal, C02 and C12 at the other terminal) may set the oscillation frequency. When both oscillator cores 711, 721 are active, the capacitances add up, collectively tuning the resonator 701, which may facilitate that the oscillation frequency remains synchronized across both transceivers 320a-b. For this purpose, the capacitor controller may dynamically adjust the capacitance values of C01, C02, C11, and C12 based on a determination of the oscillator signals' frequencies. In an example, if frequency deviations are detected, the capacitor controller may fine-tune the capacitances to restore the desired frequency. Furthermore, the inverter controller may selectively activate or deactivate the inverting amplifiers 815, 825 of the oscillator cores 711, 721. For instance, when only one transceiver is active, the corresponding inverting amplifier may drive the resonator 701 individually, while the other amplifier remains deactivated.

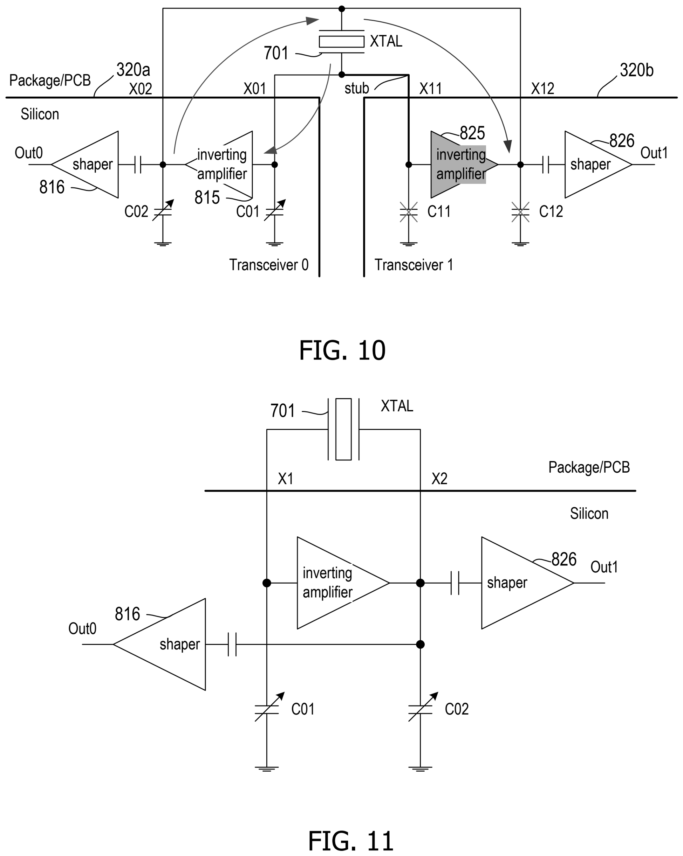

FIG. 10 illustrates an example of a circuit configuration obtainable by the circuitry described in FIG. 8. A shared quartz crystal resonator 701 coupled to two transceivers 320a and 320b through terminals X01, X02, X11, and X12 is depicted. In a configuration, the circuitry may be configured to operate in a scenario in which only one inverting amplifier is active. Illustratively, the inverting amplifier 815 of transceiver 0 320a may be configured to actively drive the resonator 701, while the inverting amplifier 825 remains deactivated. This setup may highlight an energy-efficient mode of operation, where the resonator 701 generates oscillations at a desired frequency, driven exclusively by a single inverting amplifier.

In this example, the inverting amplifier 815 may amplify the oscillations received from the resonator 701 through terminal X01 and feedback the amplified first drive signal to terminal X02. The feedback loop may facilitate a sustained oscillation at the resonant frequency of the resonator 701. The first shaper 816 connected to the output of the inverting amplifier 815 may process the sinusoidal signal into a square wave, which may be used as the first oscillator signal for subsequent circuitry within transceiver 0 320a. On the other hand, the inverting amplifier 325 of transceiver 1 320b may be deactivated, as indicated by the stub connection at terminal X11. In this mode, transceiver 1 320b may not actively contribute to driving the resonator 701. However, the resonator's oscillations may still be delivered to the input of the second shaper 826 via terminal X12. The second shaper 826 may process these oscillations into a second square wave, which may serve as the second oscillator signal for transceiver 1 320b. While the phase noise and jitter characteristics of Out1 may differ from Out 1 slightly due to the inactive state of the second inverting amplifier 825, the frequency of the signal may remain synchronized with the primary oscillator signal Out0.

The tuning capacitors C01 and C02 in transceiver 0 320a, along with the tuning capacitors C11 and C12 in transceiver 1 320b, may remain connected in parallel to the resonator 701. The capacitance values may collectively influence the oscillation frequency of the resonator. The sum of the capacitances at each terminal-C01 and C11 at X01, and C02 and C12 at X02- may define the effective tuning for the shared oscillator. When the inverting amplifier 825 is deactivated, its associated capacitors may remain passive contributors to the overall capacitance.

The capacitor controller may optionally adjust the capacitance values dynamically to fine-tune the oscillation frequency as needed. In an example, the capacitor controller may disconnect the tuning capacitors of the inverting amplifier that has been deactivated as illustrated herein. Similarly, the inverter controller may selectively activate or deactivate the inverting amplifiers 815, 825. The ability to individually control the operational state of each transceiver further enhances the versatility and energy efficiency of the communication circuitry.

FIG. 11 illustrates a schematic example of an equivalent circuit configuration based on the circuitry shown in FIG. 10, illustrating the operation of a single active inverting amplifier with reduced parasitic loading to the resonator 701. In this configuration, the inverting amplifier 815 of transceiver 0 320a may actively drive the resonator 701, while the capacitors C11 and C12 associated with the inverting amplifier 825 of transceiver 1 320b may be disconnected. This disconnection may minimize parasitic capacitance effects on the resonator 701.

In this configuration, the inverting amplifier 815 may receive oscillations from the resonator 701 at terminal X01, amplify them, and feed the amplified first drive signal back into the resonator through terminal X02. This feedback may sustain oscillations at the resonant frequency of the resonator 701. The first shaper 816, coupled to the output of the inverting amplifier 815, may process the amplified sinusoidal signal into a square wave to provide output from Out0. This first oscillator signal may be used as a more precise and a lower-phase-noise reference clock for subsequent circuitry within Transceiver 0 320a compared to the second oscillator signal.

On the other hand, the inverting amplifier 825 of transceiver 1 320b may be deactivated, and its capacitors C11 and C12 may be disconnected. This setup may reduce the load on the resonator 701 and allow the inverting amplifier 815 to maintain stable oscillations without interference from the inactive amplifier. Despite the deactivation of the inverting amplifier 825, the resonator's oscillations may be delivered to the second shaper 826 through terminal X12. The second shaper 826 may convert the sinusoidal oscillations into a square wave to provide output from Out1, which serves as the second oscillator signal for transceiver 1 320b. While Out1 may exhibit slightly different noise characteristics compared to Out0 due to the inactive state of its corresponding amplifier, its frequency may remain synchronized with Out0, ensuring consistent operation across both transceivers.

In this configuration, the tuning capacitors C01 and C02 in transceiver 0 320a may be used to set the oscillation frequency of the resonator 701. The disconnected capacitors C11 and C12 from transceiver 1 320b may no longer contribute to the effective capacitance at the terminals X01 and X02 to minimize unwanted loading effects on the resonator 701 and facilitate frequency calibration through the active capacitors. The capacitor controller may dynamically manage the connection or disconnection of tuning capacitors based on the operational state of the inverting amplifiers 815, 825.

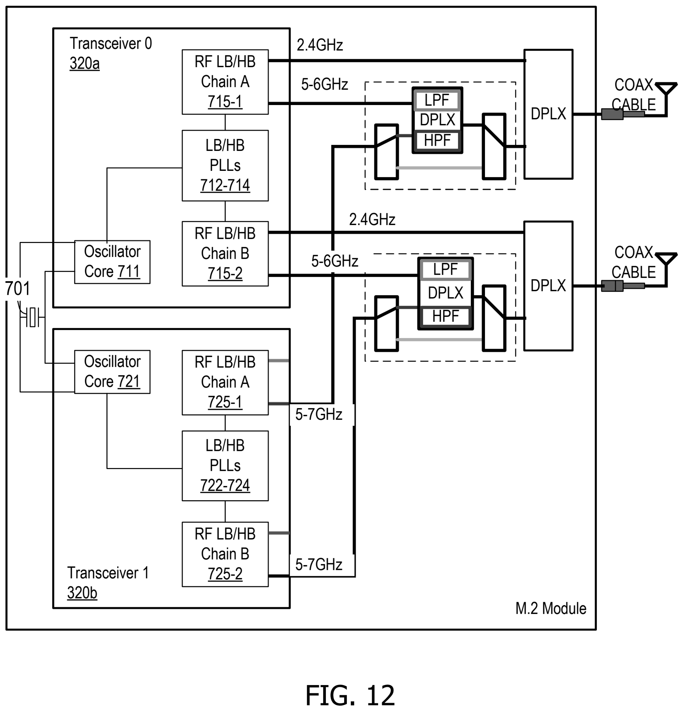

FIG. 12 illustrates a multi-band radio communication circuit. The multi-band radio communication circuit includes the communication circuitry described in accordance with FIG. 7. Illustratively, the multi-band radio communication circuit may be an example of a Wi-Fi triple band dual concurrent system operating across the 2.4 GHz, 5-6 GHz, and 6-7 GHz frequency bands. The multi-band radio communication circuit employs the communication circuitry including two transceivers 320a, 320b sharing a single quartz crystal resonator 701 to provide synchronized reference clocks for efficient communication in multiple frequency bands. The resonator 701 is coupled to both transceivers 320a-320b in a parallel configuration. Oscillator cores 711, 721 within the transceivers 320a-b may generate oscillator signals based on the resonator's oscillations. In this example, each transceiver 320a-b includes its respective phase-locked loop circuits 712-714 and the transmitter and receiver circuitry 725 including radio frequency (RF) chains 725-1, 725-2. The oscillator cores 711, 721 may drive the resonator 701.

The first transceiver circuit 320a may include a first RF chain 715-1 and a second RF-chain 715-2, each configured to modulate or demodulate communication signals in the 2.4 GHz frequency band and in the 5-6 GHz frequency band. These RF chains may receive their input oscillator signals from the phase-locked loops 712-714 that processes the first oscillator signal generated by the first oscillator core 711. The phase-locked loops 712-714 may be implemented separately as low band (LB) and high band (HB) phase-locked loops to provide corresponding phase locked loop output signals to the RF chains 715-1, 715-2.

Similarly, the second transceiver circuit 320b may include two RF chains, a first RF chain 725-1, and a second RF chain 725-2, each configured for operation in the 5-7 GHz frequency bands. These RF chains 725-1, 725-2 may utilize phase-locked outputs derived from the second oscillator signal generated by the second oscillator core 701, in which the phase-locked output may be provided by the phase-locked loops 722-724. The phase-locked loops 722-724 may be implemented separately as low band (LB) and high band (HB) phase-locked loops to provide corresponding phase locked loop output signals to the RF chains 725-1, 725-2.

Each first RF chain 715-1, 725-1 of the first and second transceivers 320a-b, may be coupled to one or more first antennas via a respective filter and diplexer circuit and a coaxial cable. Similarly, each second RF chain 715-2, 725-2 of the first and second transceivers 320a-b, may be coupled to one or more second antennas via a further respective filter and diplexer circuit and a further coaxial cable for multi-band radio communication operation. The shared resonator 701 may enable synchronization between the transceivers 320a-b, to ensure that the oscillator signals for all frequency bands remain frequency-locked despite individual RF chain operations. In this implementation, the resonator's resonant frequency may be fine-tuned by its associated tuning capacitors in the respective oscillator cores 711, 721. The tuning process may facilitate frequency accuracy across all bands.

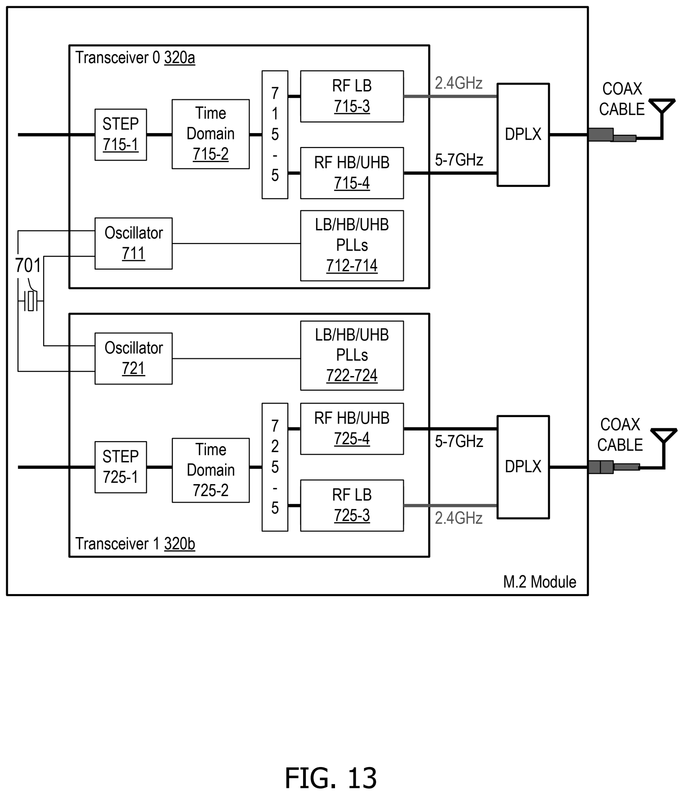

FIG. 13 illustrates a multiple input multiple output (MIMO) communication circuit. The MIMO communication circuit may include the communication circuitry described in accordance with FIG. 7. Illustratively, the MIMO communication circuit may be a Wi-Fi 2x2 Multiple Input Multiple Output system including two transceiver integrated circuits 320a-b, sharing a single quartz crystal resonator 701 . The quartz crystal resonator 701 may act as a synchronized reference clock source for both transceivers 320a-b for MIMO communication.

The first transceiver circuit, transceiver 320a, may include the oscillator core 711 electrically coupled to the resonator 701. Oscillator core 711 may generate a first oscillator signal, which is processed by phase-locked loop circuits 712, 713, and 714. These phase-locked loops may correspond to the LB, HB, and ultra-high-band (UHB) frequencies, respectively, and provide phase-locked signals at respective frequency bands to the RF chains 715-3 and 715-4. For example, RF chain 715-3 may be configured for the 2.4 GHz frequency band, while RF chain 715-4 may support operations in the 5-7 GHz band. Each RF chain may be connected to its respective filter and diplexer circuit, which may interface with external antennas through coaxial cables for communication tasks, including transmission and reception.

The STEP (serial time encoded protocol) circuit 715-1 may be configured for initial signal conditioning tasks, which may include amplification, filtering, and spatial processing techniques to encode and decode serial data streams, which may optimize multiple data streams for MIMO operations to enhance signal quality and minimize interference. The time domain circuit 715-2 may facilitate time-domain processing, encode digital information into time variables during transmission and performing time-domain quantization during reception, which may also support space-time coding for spatial diversity of MIMO systems. The block 715-5 may represent a stage including modulation and demodulation, which may include a conversion of an intermediate frequency. This stage may include mixers and amplifiers and may operate with the signals provided by the PLLs 712-714.

Similarly, transceiver 320b may include an oscillator core 721 coupled to the shared resonator 701 to generate a second oscillator signal. This signal may be processed by PLLs 722, 723, and 724, corresponding to LB, HB, and UHB frequency ranges. The phase-locked loops may provide phase-locked signals at respective frequency bands to RF chains 725-3 and 725-4, for managing communication in the 2.4 GHz and 5-7 GHz bands, respectively. These RF chains 725-3, 725-4 may be connected to antennas through filter and diplexer circuits and coaxial cables. The STEP block 725-1 in transceiver 320b may perform signal conditioning, spatial processing, and interference mitigation, similar to its counterpart in transceiver 320a. The Time Domain block 725-2 may facilitate time-domain encoding and quantization. The block 725-5 may also provide frequency conversion.

The shared resonator 701 may facilitate synchronized clocking for both transceivers 320a-b, enabling frequency-locked operations across all bands. Tuning capacitors associated with oscillator cores 711 and 721 may allow fine adjustments to the resonator's frequency. Such a configuration may support efficient, concurrent operation of both transceivers, making it well-suited for complex MIMO communication scenarios, as illustrated herein.

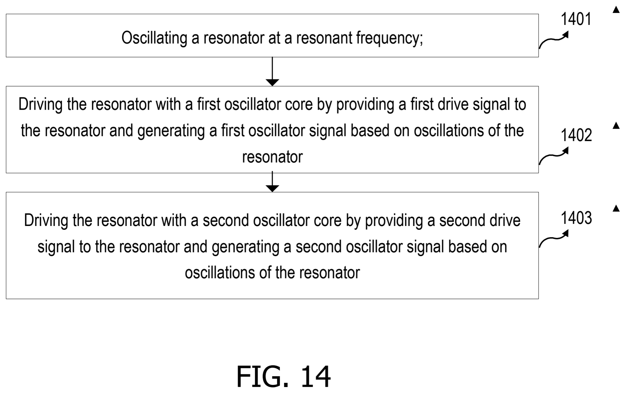

FIG. 14 shows an example of a method. The method may include: oscillating 1401 a resonator at a resonant frequency; driving 1402 the resonator with a first oscillator core by providing a first drive signal to the resonator and generating a first oscillator signal based on oscillations of the resonator; and driving 1403 the resonator with a second oscillator core by providing a second drive signal to the resonator and generating a second oscillator signal based on oscillations of the resonator.

The following examples pertain to further aspects described herein.

Example 1 is a subject matter including an apparatus that may include: a resonator configured to oscillate at a resonant frequency; a first oscillator core and a second oscillator core coupled to the resonator in a parallel configuration; the first oscillator core configured to drive the resonator by providing a first drive signal and generate a first oscillator signal based on oscillations of the resonator; the second oscillator core configured to drive the resonator by providing a second drive signal and generate a second oscillator signal based on the oscillations of the resonator.

Example 2 may include the subject matter of example 1, wherein the resonator is a single quartz crystal resonator.

Example 3 may include the subject matter of example 1 or example 2, wherein the first oscillator core and the second oscillator core are configured to operate concurrently.

Example 4 may include the subject matter of any one of examples 1 to 3, may further include a core controller configured to activate an operation of the first oscillator core and the second oscillator core; wherein the core controller is further configured to activate one of the first oscillator core or the second oscillator core individually, for example, irrespective of an activation state of the other one of the first oscillator core or the second oscillator core.

Example 5 may include the subject matter of any one of examples 1 to 4, wherein the first oscillator core is coupled to the resonator at a first terminal and a second terminal; wherein the second oscillator core is coupled to the resonator at the first terminal and the second terminal.

Example 6 may include the subject matter of any one of examples 1 to 5, wherein the first oscillator core includes: a first inverting amplifier configured to amplify the oscillations of the resonator received from the first terminal to obtain the first drive signal; wherein an output of the first inverting amplifier is coupled to the second terminal to provide the first drive signal to the resonator; a first shaper coupled to the output of the first inverting amplifier and configured to generate the first oscillator signal based on the first drive signal.

Example 7 may include the subject matter of example 6, wherein the first inverting amplifier includes an input configured to receive the oscillations of the resonator; wherein the first oscillator core further includes a first tuning capacitor coupled to the input of the first inverting amplifier and a second tuning capacitor coupled to the output of the first inverting amplifier.

Example 8 may include the subject matter of example 7, wherein the second oscillator core includes: a second inverting amplifier configured to amplify the oscillations of the resonator received from the first terminal to obtain the second drive signal, wherein an output of the second inverting amplifier is coupled to the second terminal to provide the second drive signal to the resonator; a second shaper coupled to the output of the second inverting amplifier and configured to generate the second oscillator signal based on the second drive signal.

Example 9 may include the subject matter of example 8, wherein the second inverting amplifier includes an input configured to receive the oscillations of the resonator; wherein the second oscillator core further includes a first tuning capacitor coupled to the input of the second inverting amplifier and a second tuning capacitor coupled to the output of the second inverting amplifier.

Example 10 may include the subject matter of example 9, may further include: a capacitor controller configured to: tune the tuning capacitors of the first oscillator core and the second oscillator core based on a determination of a frequency of the first oscillator signal and the second oscillator signal.

Example 11 may include the subject matter of example 10, wherein the capacitor controller is further configured to disconnect one of the tuning capacitors of the first oscillator core or the tuning capacitors of the second oscillator core individually.

Example 12 may include the subject matter of any one of example 8 to 11, may further include an inverter controller configured to activate an operation of the first inverting amplifier and the second inverting amplifier; wherein the inverter controller is further configured to activate one of the first inverting amplifier or the second inverting amplifier individually, for example, irrespective of an activation state of the other one of the first inverting amplifier or the second inverting amplifier.

Example 13 may include the subject matter of example 12, wherein the inverter controller is further configured to deactivate the first inverting amplifier; wherein the first shaper is configured to generate the first oscillator signal based on a signal received at the second terminal when the first inverting amplifier is deactivated.

Example 14 may include the subject matter of any one of examples 1 to 13, may further include: a first transceiver circuit including: the first oscillator core; at least one first communication circuit coupled to the first oscillator core and configured to receive the first oscillator signal and perform at least one of the following using the first oscillator signal: transmit one or more first communication signals or receive one or more first communication signals; a second transceiver circuit including: the second oscillator core; at least one second communication circuit coupled to the second oscillator core and configured to receive the second oscillator signal and perform at least one of the following using the second oscillator signal: transmit one or more second communication signals or receive one or more second communication signals.

Example 15 may include the subject matter of example 14, may further include: a transceiver controller configured to control the at least one first communication circuit and the at least one second communication circuit.

Example 16 may include the subject matter of example 14 or example 15, wherein the first transceiver circuit includes at least one phase locked loop configured to generate a phase locked signal based on the first oscillator signal; wherein the second transceiver circuit includes at least one further phase locked loop configured to generate a further phase locked signal based on the second oscillator signal.

Example 17 may include the subject matter of example 16, wherein the first transceiver circuit includes a first radio frequency (RF) chain configured to modulate or demodulate the one or more first communication signals based on the phase locked signal; wherein the second transceiver circuit includes a second radio frequency chain configured to modulate or demodulate the one or more second communication signals based on the further phase locked signal.

Example 18 may include the subject matter of any one of examples 14 to 17, wherein the first transceiver circuit is configured to transmit or receive the one or more first communication signals at a first frequency band; wherein the second transceiver circuit is configured to transmit or receive the one or more second communication signals at a second frequency band.

Example 19 may include the subject matter of any one of examples 14 to 17, wherein the first transceiver circuit and the second transceiver circuit are configured to perform multiple input multiple output (MIMO) communication via the one or more first communication signals and the one or more second communication signals.

Example 20 may include the subject matter of any one of examples 1 to 19, may further include an integrated circuit and a package or a printed circuit board (PCB), wherein the package or the PCB includes the resonator and the integrated circuit includes the first oscillator core and the second oscillator core.

Example 21 may include the subject matter of a method including: oscillating a resonator at a resonant frequency; driving the resonator with a first oscillator core by providing a first drive signal to the resonator and generating a first oscillator signal based on oscillations of the resonator; and driving the resonator with a second oscillator core by providing a second drive signal to the resonator and generating a second oscillator signal based on oscillations of the resonator.

Example 22 may include the subject matter of example 21, wherein the resonator is a single quartz crystal resonator.

Example 23 may include the subject matter of example 21 or example 22, may further include operating the first oscillator core and the second oscillator core concurrently.

Example 24 may include the subject matter of any one of examples 21 to 23, may further include: activating an operation of the first oscillator core and the second oscillator core using a core controller; and activating one of the first oscillator core or the second oscillator core individually, for example, irrespective of an activation state of the other one of the first oscillator core or the second oscillator core.

Example 25 may include the subject matter of any one of examples 21 to 24, may further include: coupling the first oscillator core to the resonator at a first terminal and a second terminal; and coupling the second oscillator core to the resonator at the first terminal and the second terminal.

Example 26 may include the subject matter of any one of examples 21 to 25, may further include: amplifying, by a first inverting amplifier of the first oscillator core, the oscillations of the resonator received from the first terminal to obtain the first drive signal; providing the first drive signal to the resonator by coupling an output of the first inverting amplifier to the second terminal; and generating the first oscillator signal based on the first drive signal using a first shaper coupled to the output of the first inverting amplifier.

Example 27 may include the subject matter of example 26, may further include: receiving, by an input of the first inverting amplifier, the oscillations of the resonator; and tuning the oscillations using a first tuning capacitor coupled to the input of the first inverting amplifier and a second tuning capacitor coupled to the output of the first inverting amplifier.

Example 28 may include the subject matter of example 27, may further include: amplifying, by a second inverting amplifier of the second oscillator core, the oscillations of the resonator received from the first terminal to obtain the second drive signal; providing the second drive signal to the resonator by coupling an output of the second inverting amplifier to the second terminal; and generating the second oscillator signal based on the second drive signal using a second shaper coupled to the output of the second inverting amplifier.

Example 29 may include the subject matter of example 28, may further include: receiving, by an input of the second inverting amplifier, the oscillations of the resonator; and tuning the oscillations using a first tuning capacitor coupled to the input of the second inverting amplifier and a second tuning capacitor coupled to the output of the second inverting amplifier.

Example 30 may include the subject matter of example 29, may further include: tuning the tuning capacitors of the first oscillator core and the second oscillator core based on a determination of a frequency of the first oscillator signal and the second oscillator signal.

Example 31 may include the subject matter of example 30, may further include disconnecting one of the tuning capacitors of the first oscillator core or the tuning capacitors of the second oscillator core individually, for example individually, irrespective of a connection state of other tuning capacitors using the capacitor controller.

Example 32 may include the subject matter of any one of examples 28 to 31, may further include: activating the operation of the first inverting amplifier and the second inverting amplifier using an inverter controller; and activating one of the first inverting amplifier or the second inverting amplifier individually, irrespective of the other using the inverter controller.

Example 33 may include the subject matter of example 32, may further include: deactivating the first inverting amplifier using the inverter controller; and generating the first oscillator signal based on a signal received at the second terminal when the first inverting amplifier is deactivated.

Example 34 may include the subject matter of any one of examples 21 to 33, may further include: receiving, by at least one first communication circuit of a first transceiver circuit, the first oscillator signal from the first oscillator core; performing at least one of transmitting one or more first communication signals or receiving one or more first communication signals using the first oscillator signal; receiving, by at least one second communication circuit of a second transceiver circuit, the second oscillator signal from the second oscillator core; and performing at least one of transmitting one or more second communication signals or receiving one or more second communication signals using the second oscillator signal.

Example 35 may include the subject matter of example 34, may further include controlling the at least one first communication circuit and the at least one second communication circuit using a transceiver controller.

Example 36 may include the subject matter of example 34 or example 35, may further include: generating, by at least one phase-locked loop of the first transceiver circuit, a phase-locked signal based on the first oscillator signal; and generating, by at least one further phase-locked loop of the second transceiver circuit, a further phase-locked signal based on the second oscillator signal.

Example 37 may include the subject matter of example 36, may further include: modulating or demodulating the one or more first communication signals based on the phase-locked signal using a first radio frequency processing chain of the first transceiver circuit; and modulating or demodulating the one or more second communication signals based on the further phase-locked signal using a second radio frequency processing chain of the second transceiver circuit.

Example 38 may include the subject matter of any one of examples 34 to 37, may further include: transmitting or receiving the one or more first communication signals at a first frequency band using the first transceiver circuit; and transmitting or receiving the one or more second communication signals at a second frequency band using the second transceiver circuit.

Example 39 may include the subject matter of any one of examples 34 to 37, may further include performing multiple input multiple output (MIMO) communication using the first transceiver circuit and the second transceiver circuit via the one or more first communication signals and the one or more second communication signals.

Example 40 may include the subject matter of any one of examples 21 to 39, may further include: providing the resonator on a package or a printed circuit board; and integrating the first oscillator core and the second oscillator core on an integrated circuit.

Example 41 may include a non-transitory computer-readable medium including instructions which, if executed by a processor, cause a system including the processor to perform the subject matter of any one of examples 21 to 40.

The word "exemplary" is used herein to mean "serving as an example, instance, or illustration". Any embodiment or design described herein as "exemplary" is not necessarily to be construed as preferred or advantageous over other embodiments or designs.

The words "plurality" and "multiple" in the description or the claims expressly refer to a quantity greater than one. The terms "group (of)", "set [of]", "collection (of)", "series (of)", "sequence (of)", "grouping (of)", etc., and the like in the description or in the claims refer to a quantity equal to or greater than one, i.e. one or more. Any term expressed in plural form that does not expressly state "plurality" or "multiple" likewise refers to a quantity equal to or greater than one.

Any vector and/or matrix notation utilized herein is exemplary in nature and is employed solely for purposes of explanation. Accordingly, the apparatuses and methods described herein accompanied by vector and/or matrix notation are not limited to being implemented solely using vectors and/or matrices, and that the associated processes and computations may be equivalently performed with respect to sets, sequences, groups, etc., of data, observations, information, signals, samples, symbols, elements, etc.

As used herein, "memory" is understood as a non-transitory computer-readable medium in which data or information can be stored for retrieval. References to "memory" included herein may thus be understood as referring to volatile or non-volatile memory, including random access memory ("RAM"), read-only memory ("ROM"), flash memory, solid-state storage, magnetic tape, hard disk drive, optical drive, etc., or any combination thereof. Furthermore, registers, shift registers, processor registers, data buffers, etc., are also embraced herein by the term memory. A single component referred to as "memory" or "a memory" may be composed of more than one different type of memory, and thus may refer to a collective component including one or more types of memory. Any single memory component may be separated into multiple collectively equivalent memory components, and vice versa. Furthermore, while memory may be depicted as separate from one or more other components (such as in the drawings), memory may also be integrated with other components, such as on a common integrated chip or a controller with an embedded memory.

The term "software" refers to any type of executable instruction, including firmware.

In the context described herein, the term "process" may be used, for example, to indicate a method. Illustratively, any process described herein may be implemented as a method (e.g., a channel estimation process may be understood as a channel estimation method). Any process described herein may be implemented as a non-transitory computer readable medium including instructions configured, when executed, to cause one or more processors to carry out the process (e.g., to carry out the method).

Throughout the drawings, it should be noted that like reference numbers are used to depict the same or similar elements, features, and structures, unless otherwise noted. It should be noted that certain components may be omitted for the sake of simplicity. It should be noted that nodes (dots) are provided to identify the circuit line intersections in the drawings including electronic circuit diagrams.

The phrase "at least one" and "one or more" may be understood to include a numerical quantity greater than or equal to one (e.g., one, two, three, four, [...], etc.). The phrase "at least one of" with regard to a group of elements may be used herein to mean at least one element from the group consisting of the elements. For example, the phrase "at least one of" with regard to a group of elements may be used herein to mean a selection of: one of the listed elements, a plurality of one of the listed elements, a plurality of individual listed elements, or a plurality of a multiple of individual listed elements.

The words "plural" and "multiple" in the description and in the claims expressly refer to a quantity greater than one. Accordingly, any phrases explicitly invoking the aforementioned words (e.g., "plural [elements]", "multiple [elements]") referring to a quantity of elements expressly refers to more than one of the said elements. For instance, the phrase "a plurality" may be understood to include a numerical quantity greater than or equal to two (e.g., two, three, four, five, [...], etc.).

As used herein, a signal or information that is "indicative of", "representative", "representing", or "indicating" a value or other information may be a digital or analog signal that encodes or otherwise, communicates the value or other information in a manner that can be decoded by and/or cause a responsive action in a component receiving the signal. The signal may be stored or buffered in computer-readable storage medium prior to its receipt by the receiving component and the receiving component may retrieve the signal from the storage medium. Further, a "value" that is "indicative of "or "representative" some quantity, state, or parameter may be physically embodied as a digital signal, an analog signal, or stored bits that encode or otherwise communicate the value.

As used herein, a signal may be transmitted or conducted through a signal chain in which the signal is processed to change characteristics such as phase, amplitude, frequency, and so on. The signal may be referred to as the same signal even as such characteristics are adapted. In general, so long as a signal continues to encode the same information, the signal may be considered as the same signal. For example, a transmit signal may be considered as referring to the transmit signal in baseband, intermediate, and radio frequencies.

The terms "processor" or "controller" as, for example, used herein may be understood as any kind of technological entity that allows handling of data. The data may be handled according to one or more specific functions executed by the processor. Further, a processor or controller as used herein may be understood as any kind of circuit, e.g., any kind of analog or digital circuit. A processor or a controller may thus be or include an analog circuit, digital circuit, mixed-signal circuit, logic circuit, processor, microprocessor, Central Processing Unit (CPU), Graphics Processing Unit (GPU), Digital Signal Processor (DSP), Field Programmable Gate Array (FPGA), integrated circuit, Application Specific Integrated Circuit (ASIC), etc., or any combination thereof. Any other kind of implementation of the respective functions, which will be described below in further detail, may also be understood as a processor, controller, or logic circuit. It is understood that any two (or more) of the processors, controllers, or logic circuits detailed herein may be realized as a single entity with equivalent functionality or the like, and conversely that any single processor, controller, or logic circuit detailed herein may be realized as two (or more) separate entities with equivalent functionality or the like.

The terms "one or more processors" is intended to refer to a processor or a controller. The one or more processors may include one processor or a plurality of processors. The terms are simply used as an alternative to the "processor" or "controller".

The term "user device" is intended to refer to a device of a user (e.g. occupant) that may be configured to provide information related to the user. The user device may exemplarily include a mobile phone, a smart phone, a wearable device (e.g. smart watch, smart wristband), a computer, etc.

As utilized herein, terms "module", "component," "system," "circuit," "element," "slice," " circuit," and the like are intended to refer to a set of one or more electronic components, a computer-related entity, hardware, software (e.g., in execution), and/or firmware. For example, circuit or a similar term can be a processor, a process running on a processor, a controller, an object, an executable program, a storage device, and/or a computer with a processing device. By way of illustration, an application running on a server and the server can also be circuit. One or more circuits can reside within the same circuit, and circuit can be localized on one computer and/or distributed between two or more computers. A set of elements or a set of other circuits can be described herein, in which the term "set" can be interpreted as "one or more".

The term "data" as used herein may be understood to include information in any suitable analog or digital form, e.g., provided as a file, a portion of a file, a set of files, a signal or stream, a portion of a signal or stream, a set of signals or streams, and the like. Further, the term "data" may also be used to mean a reference to information, e.g., in form of a pointer. The term "data", however, is not limited to the aforementioned examples and may take various forms and represent any information as understood in the art. The term "data item" may include data or a portion of data.

It will be understood that when an element is referred to as being "connected" or "coupled" to another element, it can be physically connected or coupled to the other element such that current and/or electromagnetic radiation (e.g., a signal) can flow along a conductive path formed by the elements. Inherently, such element is connectable or couplable to the another element. Intervening conductive, inductive, or capacitive elements may be present between the element and the other element when the elements are described as being coupled or connected to one another. Further, when coupled or connected to one another, one element may be capable of inducing a voltage or current flow or propagation of an electro-magnetic wave in the other element without physical contact or intervening components. Further, when a voltage, current, or signal is referred to as being "provided" to an element, the voltage, current, or signal may be conducted to the element by way of a physical connection or by way of capacitive, electro-magnetic, or inductive coupling that does not involve a physical connection.

Unless explicitly specified, the term "instance of time" refers to a time of a particular event or situation according to the context. The instance of time may refer to an instantaneous point in time, or to a period of time which the particular event or situation relates to.

Unless explicitly specified, the term "transmit" encompasses both direct (point-to-point) and indirect transmission (via one or more intermediary points). Similarly, the term "receive" encompasses both direct and indirect reception. Furthermore, the terms "transmit," "receive," "communicate," and other similar terms encompass both physical transmission (e.g., the transmission of radio signals) and logical transmission (e.g., the transmission of digital data over a logical software-level connection). For example, a processor or controller may transmit or receive data over a software-level connection with another processor or controller in the form of radio signals, where the physical transmission and reception is handled by radio-layer components such as RF transceivers and antennas, and the logical transmission and reception over the software-level connection is performed by the processors or controllers. The term "communicate" encompasses one or both of transmitting and receiving, i.e., unidirectional or bidirectional communication in one or both of the incoming and outgoing directions. The term "calculate" encompasses both 'direct' calculations via a mathematical expression/formula/relationship and 'indirect' calculations via lookup or hash tables and other array indexing or searching operations.

While the above descriptions and connected figures may depict electronic device components as separate elements, skilled persons will appreciate the various possibilities to combine or integrate discrete elements into a single element. Such may include combining two or more circuits to form a single circuit, mounting two or more circuits onto a common chip or chassis to form an integrated element, executing discrete software components on a common processor core, etc. Conversely, skilled persons will recognize the possibility to separate a single element into two or more discrete elements, such as splitting a single circuit into two or more separate circuits, separating a chip or chassis into discrete elements originally provided thereon, separating a software component into two or more sections and executing each on a separate processor core, etc.

It is appreciated that implementations of methods detailed herein are demonstrative in nature, and are thus understood as capable of being implemented in a corresponding device. Likewise, it is appreciated that implementations of devices detailed herein are understood as capable of being implemented as a corresponding method. It is thus understood that a device corresponding to a method detailed herein may include one or more components configured to perform each aspect of the related method. All acronyms defined in the above description additionally hold in all claims included herein.

## Claims

1. An apparatus comprising:
a resonator configured to oscillate at a resonant frequency; and
a first oscillator core and a second oscillator core coupled to the resonator in a parallel configuration;
wherein the first oscillator core is configured to drive the resonator by providing a first drive signal and to generate a first oscillator signal based on oscillations of the resonator; and
wherein the second oscillator core is configured to drive the resonator by providing a second drive signal and to generate a second oscillator signal based on the oscillations of the resonator.

2. The apparatus of claim 1,
wherein the resonator is a single quartz crystal resonator.

3. The apparatus of any one of claims 1 or 2,
wherein the first oscillator core and the second oscillator core are configured to operate concurrently.

4. The apparatus of any one of claims 1 to 3, further comprising
a core controller configured to activate an operation of the first oscillator core and the second oscillator core; and
wherein the core controller is further configured to activate one of the first oscillator core or the second oscillator core individually, irrespective of an activation state of the other one of the first oscillator core or the second oscillator core.

5. The apparatus of any one of claims 1 to 4,
wherein the first oscillator core is coupled to the resonator at a first terminal and a second terminal; and
wherein the second oscillator core is coupled to the resonator at the first terminal and the second terminal.

6. The apparatus of any one of claims 1 to 5,
wherein the first oscillator core comprises:
a first inverting amplifier configured to amplify the oscillations of the resonator received from the first terminal to obtain the first drive signal, wherein an output of the first inverting amplifier is coupled to the second terminal to provide the first drive signal to the resonator; and
a first shaper coupled to the output of the first inverting amplifier and configured to generate the first oscillator signal based on the first drive signal.

7. The apparatus of claim 6,
wherein the first inverting amplifier comprises an input configured to receive the oscillations of the resonator; and
wherein the first oscillator core further comprises a first tuning capacitor coupled to the input of the first inverting amplifier and a second tuning capacitor coupled to the output of the first inverting amplifier.

8. The apparatus of claim 7,
wherein the second oscillator core comprises:
a second inverting amplifier configured to amplify the oscillations of the resonator received from the first terminal to obtain the second drive signal, wherein an output of the second inverting amplifier is coupled to the second terminal to provide the second drive signal to the resonator; and
a second shaper coupled to the output of the second inverting amplifier and configured to generate the second oscillator signal based on the second drive signal;
preferably the apparatus further comprising an inverter controller configured to activate an operation of the first inverting amplifier and the second inverting amplifier, wherein the inverter controller is further configured to activate one of the first inverting amplifier or the second inverting amplifier individually, irrespective of an activation state of the other one of the first inverting amplifier or the second inverting amplifier.

9. The apparatus of claim 8,
wherein the second inverting amplifier comprises an input configured to receive the oscillations of the resonator; and
wherein the second oscillator core further comprises a first tuning capacitor coupled to the input of the second inverting amplifier and a second tuning capacitor coupled to the output of the second inverting amplifier;
preferably the apparatus further comprisinga capacitor controller configured to tune the tuning capacitors of the first oscillator core and the second oscillator core based on a determination of a frequency of the first oscillator signal and the second oscillator signal.

10. The apparatus of any one of claims 1 to 9, further comprising:
a first transceiver circuit comprising:
the first oscillator core; and
at least one first communication circuit coupled to the first oscillator core and configured to receive the first oscillator signal and perform at least one of the following using the first oscillator signal: transmit one or more first communication signals or receive one or more first communication signals; and
a second transceiver circuit comprising:
the second oscillator core; and
at least one second communication circuit coupled to the second oscillator core and configured to receive the second oscillator signal and perform at least one of the following using the second oscillator signal: transmit one or more second communication signals or receive one or more second communication signals;
preferably wherein the first transceiver circuit comprises at least one phase locked loop configured to generate a phase locked signal based on the first oscillator signal; wherein the second transceiver circuit comprises at least one further phase locked loop configured to generate a further phase locked signal based on the second oscillator signal.

11. The apparatus of claim 10,
wherein the first transceiver circuit is configured to transmit or receive the one or more first communication signals at a first frequency band; and
wherein the second transceiver circuit is configured to transmit or receive the one or more second communication signals at a second frequency band.

12. The apparatus of any one of claims 10 or 11,
wherein the first transceiver circuit and the second transceiver circuit are configured to perform multiple input multiple output (MIMO) communication via the one or more first communication signals and the one or more second communication signals.

13. The apparatus of any one of claims 1 to 12, further comprising
an integrated circuit and a package or a printed circuit board (PCB), wherein the package or the PCB comprises the resonator and the integrated circuit comprises the first oscillator core and the second oscillator core.

14. A method comprising:
oscillating a resonator at a resonant frequency;
driving the resonator with a first oscillator core by providing a first drive signal to the resonator;
generating a first oscillator signal based on oscillations of the resonator; and
driving the resonator with a second oscillator core by providing a second drive signal to the resonator and generating a second oscillator signal based on oscillations of the resonator;
preferably the method further comprising activating an operation of the first oscillator core and the second oscillator core individually.

15. A non-transitory computer-readable medium comprising instructions which, if executed by a processor, cause a system including the processor to:
oscillate a resonator at a resonant frequency;
drive the resonator with a first oscillator core by providing a first drive signal to the resonator;
generate a first oscillator signal based on oscillations of the resonator; and
drive the resonator with a second oscillator core by providing a second drive signal to the resonator and generating a second oscillator signal based on oscillations of the resonator;
preferably wherein the instructions further cause the system to activate an operation of the first oscillator core and the second oscillator core individually.
